(19) Europäisches Patentamt
European Patent Office
Office européen des brevets

(11) **EP 4 376 167 A2**

(12) **EUROPÄISCHE PATENTANMELDUNG**

(43) Veröffentlichungstag:
**29.05.2024  Patentblatt 2024/22**

(21) Anmeldenummer: **24162524.3**

(22) Anmeldetag: **30.08.2023**

(51) Internationale Patentklassifikation (IPC):
**H01M 10/48** (2006.01)

(52) Gemeinsame Patentklassifikation (CPC):
**G01R 31/367; G01R 31/007; H01M 10/425;
H01M 10/48; H01M 10/482;** H01M 2010/4271

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(30) Priorität: **09.09.2022  BE 202200058**

(62) Dokumentnummer(n) der früheren Anmeldung(en)
nach Art. 76 EPÜ:
**23767813.1 / 4 370 940**

(71) Anmelder: **volytica diagnostics GmbH
01097 Dresden (DE)**

(72) Erfinder:
• **Jehle, Claudius
  München (DE)**
• **Morawietz, Lutz
  Dresden (DE)**

(74) Vertreter: **Rössler, Thomas
Luxpatent Intellectual Property
Zavelput 17
1000 Brussel (BE)**

Bemerkungen:
Diese Anmeldung ist am 10-03-2024 als
Teilanmeldung zu der unter INID-Code 62 erwähnten
Anmeldung eingereicht worden.

(54) **COMPUTERPROGRAMM UND VERFAHREN ZUR ANALYSE VON INHOMOGENITÄTEN SOWIE
ANOMALIEDETEKTION UND -VORHERSAGE VON ELEKTRISCHEN ENERGIESPEICHERN**

(57)    Die vorliegende Erfindung bezieht sich auf ein Computerprogramm und ein Verfahren zum Erkennen und/oder Vorhersehen von Anomalien in einem Batteriesystem, umfassend zwei oder mehrere Batteriezellen-Elemente, umfassend die folgenden Schritte: Bereitstellen eines reduzierten Batteriezellen-Element-Mess-Datensatzes, welcher auf Basis eines Batteriezellen-Element-Mess-Datensatzes, welcher je Batteriezellen-Element des Batteriesystems eine oder mehrere erste Zustandsgrößen, insbesondere Temperatur, Stromfluss und/oder Spannung und/oder erste Zustandsgrößen, welche durch Kombinationen hieraus beschrieben sind, des jeweiligen Batteriezellen-Elements in Bezug auf einen oder mehrere Zeitpunkte als Messdatum umfasst, derart hergeleitet wurde, dass der reduzierte Batteriezellen-Element-Mess-Datensatzes für eine erste Zustandsgröße und für einen Zeitpunkt: ein erstes, nach einem ersten Kriterium aus der Menge der Messdaten der Batteriezellen-Elemente aus dem Batteriezellen-Element-Mess-Datensatzes, für diesen Zeitpunkt und diese erste Zustandsgröße, ausgewähltes Messdatum, sowie ein zweites, nach einem zweiten Kriterium aus der Menge der Messdaten der Batteriezellen-Elemente aus dem Batteriezellen-Element-Mess-Datensatzes, für diesen Zeitpunkt und diese erste Zustandsgröße, ausgewähltes Messdatum umfasst, Bestimmen und/oder Vorhersehen einer Anomalie des Batteriesystems auf Basis des reduzierten Batteriezellen-Element-Mess-Datensatzes, oder eines hierauf basierenden Datensatzes.

Fig. 8

## Beschreibung

### Gebiet der Erfindung

Die vorliegende Erfindung bezieht sich auf das technische Gebiet der Batterietechnik, insbesondere der Energiespeicher, insbesondere zum Betrieb elektrisch motorisierter Fahrzeuge, aber auch stationärer Batteriespeicher.

### Technischer Hintergrund

Aus dem Stand der Technik sind Batterie-Management-Systeme (BMS) bekannt. Häufig werden BMS dazu eingesetzt, auch bei Batterien/Akkumulatoren für elektrische Fahrzeuge (Fahrzeug-Energiespeicher), für stationäre Batteriespeicher und für alle anderen Einsatzbereiche von Batterien, um eine Überwachung und Regelung des Akkumulators zu gewährleisten, und beispielsweise zu deren Schutz vor ungewünschten Vorgängen (bspw. der Eintritt von Tiefentladung). Komplexe Akkumulatoren bestehen häufig aus mehreren Zellen, welche parallel und/oder seriell verschaltet sein können. Häufig kommen auch hierarchische Organisationsstrukturen zum Einsatz, beispielsweise in Form von Zellengruppen (und -übergruppen und/oder -subgruppen etc.). Im Sinne der Erfindung wird somit unter "Zelle" oder "Batteriezelle" oder "Batterieelement" sowohl eine einzelne Zelle, als auch eine Verschaltung von Zellen verstanden.

Benannte unerwünschte Vorgänge reichen von

- abweichendes und beeinträchtigtes Systemnutzungsverhalten wie bspw. reduzierte Energiespeicherungs-/Leistungsfähigkeit durch unterschiedliche Alterung von Widerständen und Kapazitäten, über
- plötzlichen Stillständen oder Leistungseinbußen bzw. plötzlichem - oft nur scheinbaren - Verlust der Energiebereitstellung/-aufnahmefähigkeit ("sudden depletion events", ausgelöst durch eine zu große Spreizung des Ladungs-/Energiegehalts (State of Charge/SOC) und/oder durch eine zu große Spreizung der (verbleibenden) Maximalkapazität (State of Health/SOH) unter der Gesamtheit der Batterieelemente), bis hin zu
- Ausfall (teilweise irreversibler/katastrophaler) einzelner Batterieelemente (End of Life, Kneepoint/Knickpunkt, Leckage, Ruptur, Feuer, Brand, Thermal Runaway), oft ausgelöst durch Verschleiß, Korrosion, Versagen, Degradieren sowie aller anderen Formen von geplanter und/oder ungeplanter Qualitätsänderung von Materialien an, in oder bei den Zellen und Batterieelementen sowie deren elektrischen Verbindungselementen, Sensoren und deren Peripherie. Hierzu gehört bei Li-Ionenbasierten Batterien insbesondere Li-Plating bzw. das Aufbauen zell-interner Defekte, bspw. durch Entstehung metallischen Lithiums, was zur Durchstechung von Schutzmembranen führen kann.

Vorgenannte Effekte sind beispielhaft und keineswegs abschließend. Oft sind sie oder Kombinationen daraus auf ein uneinheitliches Verhalten der Vielzahl an Batterieelementen zurückzuführen. Diese Verhaltensunterschiede sind meist auf unterschiedliche Qualitäten, Zustandsgrößen oder Kennzahlen der Batterieelemente zurückzuführen, so bspw. Unterschiede im Ladungszustand SOC, in der Kapazität C/SOH, im Widerstands-/Impedanzverhalten usw.

Es ist theoretisch zielführend, den Verlauf der einzelnen Qualitäten aller Batterieelemente über weite Zeiträume, insbesondere über Tage bis Jahre hinweg, auf Trends, Anomalien oder unerwartete Änderungen hin zu überwachen, um unerwünschten Vorgängen vorzubeugen.

Die genannten Batterie-Management-Systeme haben häufig Zugang zu den dazu nötigen enormen Datenmengen. Selbst Batteriesysteme von wenigen kWh beinhalten jedoch bereits Dutzende bis Hunderte einzelne Zellen, die nach dem Stand der Technik jede einzeln von den BMS überwacht werden. So hat eine übliche PKW-Batterie mit 50kWh ca. 100-1000 einzelne Zellen. Nachteilig ist somit, dass diese Datenmengen selbst für kurze Zeiträume von Sekunden bis Stunden sehr groß und umfangreich sind, was eine ressourcenschonende Weiterverarbeitung und/oder Speicherung erschwert, und eine Langzeitverfolgung über Tage bis Jahre auf BMS heute unwirtschaftlich macht. Das Potential dieser Datenmengen bleibt im Wesentlichen ungenutzt.

In den meisten Anwendungsfällen ist daher eine direkte Verwertung und/oder Speicherung sämtlicher zugänglicher Daten allein aus Ressourcengründen bereits unrealistisch.

Durch diese technischen Schwierigkeiten sind effektive Detektionen von, insbesondere schleichend, eintretenden Anomalien in Batteriesystemen und insbesondere deren präventive Vorhersage bisher nicht möglich.

Aus den genannten Ressourcengründen sind umfassende Einzelanalysen für jede Einzelzelle - selbst im BMS - nicht wirtschaftlich und technisch nicht angemessen, während lediglich eine Betrachtung eines Gesamtakkumulators, beispielsweise als lediglich eine Gesamteinheit, viel zu unpräzise zur verlässlichen Anomaliedetektion und -vorhersage ist - und gänzlich ungeeignet, um eine Einzelzell- oder Batterielement-bedingte Anomalie rechtzeitig, insbesondere lange vor dem Eintritt substantieller Zerfalls-, Aggravations- und/oder Eskalationsvorgänge (z.B. Batteriebrand) zu erkennen.

Häufig werden Batteriedaten, teilweise in reduzierter Form, wie unten beschrieben, lokal nur zwischengespeichert und für spätere Analysen bspw. in Clouds übertragen. Bis heute sind den Erfindern aber keine Verfahren außer dem hier beschriebenen bekannt, die aus derart reduzierten Datensätzen eine zuverlässige, robuste, frühzeitige und ressourcenschonende Erkennung von Anomalien erlaubt.

Das U.S.-Patentdokument US 20210049480 A1 offenbart Systeme, Verfahren und Vorrichtungen für die vorausschauende Wartung von Autobatterien. Ein Fahrzeug verfügt beispielsweise über: einen Elektromotor; eine Batterie, die so konfiguriert ist, dass sie mindestens den Elektromotor mit Energie versorgt; einen oder mehrere Sensoren, die so konfiguriert sind, dass sie Betriebsparameter der Batterie messen; ein künstliches neuronales Netz, das so konfiguriert ist, dass es die Betriebsparameter der Batterie als Funktion der Zeit analysiert, um ein Ergebnis zu erzeugen; und mindestens einen Prozessor, der so konfiguriert ist, dass er einen Vorschlag für eine Wartung der Batterie auf der Grundlage des Ergebnisses des künstlichen neuronalen Netzes erzeugt, das die Betriebsparameter der Batterie analysiert. Der Elektromotor kann zum Beispiel Teil eines Motorstarters für einen Verbrennungsmotor oder eines Motors für ein Elektrofahrzeug sein.

In Folge bleiben enorme Erkenntnis- und Analysepotentiale von prinzipiell zugänglichen Daten ungenutzt. Dadurch werden Batterien nach dem Stand der Technik nicht optimal betrieben. Unter anderem treten Zerstörungen ganzer Batteriesysteme ein, welche mit geeigneter Vorhersage hätten vermieden werden können. Reparaturen und Rekombinationen von Batterien (bspw. Rekombination oder Tausch von Zellen und/oder Gruppen von Zellen), welche vor Eintritt einer Eskalation problemlos die Batterie hätten "retten" und wieder für den langfristigen komplikationslosen Betrieb hätten eignen können, sind nach der Eskalation (bspw. komplette Zerstörung eines gesamten Batteriesystems, beispielsweise eines gesamten Batteriesystems) kaum noch möglich, in der Regel sogar gar nicht mehr, was der Wirtschaft als auch dem Schutz der Umwelt abträglich ist.

Die vorliegende Erfindung, welche im Nachfolgenden vorgestellt wird, soll Abhilfe schaffen und ein effizientes, präzises, zugleich ressourcenschonendes und ubiquitär einsetzbares Verfahren schaffen, um Anomalien in Batteriesystemen frühzeitig zu erkennen und/oder vorherzusagen.

Die Erfindung soll möglichst feldübergreifend und endgeräteunspezifisch anwendbar sein, dabei leicht skalierbar und leicht zugänglich zu machen sein, auch beispielsweise für die Vielzahl bereits existenter Batteriesysteme, bspw. in Fahrzeugen, sodass jedermann hiervon profitieren kann.

Die Nachteile des Standes der Technik werden überwunden durch das Verfahren nach Anspruch 1 zum Erkennen und/oder Vorhersehen von Anomalien in einem Batteriesystem.

Die Erfindung trägt damit erheblich zum technischen Fortschritt in der Batterietechnik und - diagnostik, insbesondere für elektrisch betriebene Fahrzeuge und stationäre Batteriespeicher, bei. Auch der Umweltschutz spielt eine tragende Rolle.

## Beschreibung der Erfindung

Die vorliegende Erfindung schafft ein Verfahren mit den Merkmalen des Anspruchs 1.

Weitere vorteilhafte Ausgestaltungen sind in den Unteransprüchen angegeben.

Demgemäß ist ein Verfahren zum Erkennen und/oder Vorhersehen von Anomalien in einem Batteriesystem vorgesehen. Das Batteriesystem kann zwei oder mehrere Batteriezellen-Elemente umfassen.

Das Verfahren kann einen oder mehrere Schritte, ganz oder teilweise, aus den folgenden Schritten umfassen: Bereitstellen der minimalen Spannung und der maximalen Spannung im Batteriesystem als die Spannung des Batteriezellen-Elements mit der niedrigsten Spannung und die Spannung des Batteriezellen-Elements mit der höchsten Spannung, respektive, auf Basis mehrerer Einzelspannungen mehrerer Batteriezellen-Elemente, Bestimmen und/oder Vorhersehen einer Anomalie des Batteriesystems (20); auf Basis der minimalen Spannung und der maximalen Spannung; insbesondere eines oder mehrere aus: einer Abschätzung der Spreizung der Kapazität innerhalb des Batteriesystems, einer Abschätzung der Größenordnung der Abweichung der Kapazitäten von Batteriezellen-Elementen voreinander, einer Abschätzung des Vorliegens von Anzeichen für beschleunigten Kapazitätsverfall einzelner oder weniger Batteriezellen-Elemente, einer Abschätzung der Größenordnung der Abweichung von Widerständen von Batteriezellen-Elementen voreinander, einer Abschätzung des Vorliegens von Anzeichen von Defekten einzelner oder weniger Batteriezellen-Elemente, eine Abschätzung des Vorliegens von Anzeichen von Lithium-Plating und/oder Auftretens von metallischem Lithium und/oder Auftreten ungewollter metallischer Abscheidungen, eine Abschätzung des Vorliegens von Anzeichen von internen Kurzschlüssen.

Das Verfahren kann einen oder mehrere Schritte, ganz oder teilweise, aus den folgenden Schritten umfassen: Bereitstellen eines reduzierten Batteriezellen-Element-Mess-Datensatzes, welcher auf Basis eines Batteriezellen-Element-Mess-Datensatzes, welcher je Batteriezellen-Element des Batteriesystems eine oder mehrere erste Zustandsgrößen, insbesondere Temperatur, Stromfluss und/oder Spannung und/oder erste Zustandsgrößen, welche durch Kombinationen hieraus beschrieben sind, des jeweiligen Batteriezellen-Elements in Bezug auf einen oder mehrere Zeitpunkte als Messdatum umfasst, derart hergeleitet wurde, dass der reduzierte Batteriezellen-Element-Mess-Datensatzes für eine erste Zustandsgröße und für einen Zeitpunkt ein erstes, nach einem ersten Kriterium aus der Menge der Messdaten der Batteriezellen-Elemente aus dem Batteriezellen-Element-Mess-Datensatzes, für diesen Zeitpunkt und diese erste Zustandsgröße, ausgewähltes Messdatum, sowie ein zweites, nach einem zweiten Kriterium aus der Menge der Messdaten der Batteriezellen-Elemente aus dem Batteriezellen-Element-Mess-Datensatzes, für diesen Zeitpunkt und diese erste Zustandsgröße, ausgewähltes Messdatum umfasst, oder eines auf dem reduzierten Batteriezellen-Element-Mess-Datensatz basierenden Datensatzes (bzw. eines auf einem reduzierten Batteriezellen-Element-Mess-Datensatz, gemäß der vorhergehenden Definition eines reduzierten Batteriezellen-Element-Mess-Datensatzes, basierenden Datensatzes); Bestimmen und/oder Vorhersehen einer Anomalie des Batteriesystems auf Basis des reduzierten Batteriezellen-Element-Mess-Datensatzes und/oder auf Basis des auf dem reduzierten Batteriezellen-Element-Mess-Datensatzes basierenden Datensatzes.

Die Erfindung schafft damit insbesondere ein besonders effizientes Verfahren zum Erkennen und/oder Vorhersehen von Anomalien in einem Batteriesystem.

Das Batteriesystem kann ein Energiespeicher für ein Kraftfahrzeug sein, insbesondere ein solcher für ein elektrisches Kraftfahrzeug. Ein solches Kraftfahrzeug kann beispielsweise durch die von der Batterie zur Verfügung gestellte Energie elektro-motorisiert fahren. Das Batteriesystem kann ein Energiespeicher für ein Stationärspeicher sein, insbesondere ein solcher für die zeitweise Speicherung überschüssiger elektrischer Energie (Pufferspeicher, Regelleistung, Peakshaving, Heimspeicher). Das Batteriesystem basiert bevorzugterweise auf Akkumulatoren/Sekundärzellen.

Ein Batteriesystem umfasst zwei oder mehr Batteriezellen-Elemente. Batteriezellen-Elemente können (insbesondere elementare) Batteriezellen sein, aber auch Gruppen oder Cluster von Batteriezellen sind wiederum Batteriezellen-Elemente. Auch Gruppen oder Cluster von Batteriezellen-Elementen sind wiederum als Batteriezellen-Elemente aufzufassen. In einer bevorzugten Ausführungsform handelt es sich um elementare Batteriezellen oder um (beispielsweise auch in ihrer Größe standardisierte) Blocks bzw. Gruppen von Batteriezellen (Module, Racks, Stränge, Container). Batteriezellen als auch Batteriezellen-Elemente können beispielsweise parallel, seriell oder anderweitig miteinander verschaltet sein.

Zur Nutzung der Erfindung wird als vorgelagerter Schritt, und möglicherweise durch einen Dritten, ein reduzierter Batteriezellen-Element-Mess-Datensatz erzeugt, insbesondere aus einem umfangreicheren Batteriezellen-Element-Mess-Datensatz, und insbesondere durch ein Batteriemanagement-System, und dieser wird sodann bereitgestellt und insbesondere vom lokalen Batteriesystem oder Batteriemanagementsystem über ein geeignetes Übertragungsmittel, insbesondere Telematikeinheiten, an Clouds übertragen, und für die Analyse genutzt. Dies ist besonders ressourcenschonend. Ein umfassenderer oder gar vollständiger Batteriezellen-Element-Mess-Datensatz wird so nicht benötigt und auch nicht unter hohen Ressourcenaufwendungen ausgewertet. Die Erfindung kommt also mit einem reduzierten Batteriezellen-Element-Mess-Datensatz als Eingangsgröße aus.

Um im Rahmen der Erfindungsbeschreibung ein verbessertes Verständnis der Natur des reduzierten Batteriezellen-Element-Mess-Datensatzes zu ermöglichen, führen wir jedoch seine Erzeugung aus einem (umfassenderen) Batteriezellen-Element-Mess-Datensatzes beschreibend aus. Dieser Schritt ist jedoch kein wesentliches Merkmal der Erfindung, und dies wird daher lediglich zu einem besseren Verständnis des reduzierten Batteriezellen-Element-Mess-Datensatzes erläutert, mit welchem die Erfindung arbeitet und auf welchem die erfindungsgemäße Analyse basiert. Es sei betont, dass es sich hierbei also um einen einer möglichen Anwendung der vorliegenden Erfindung lediglich vorgelagerten Schritt handelt, welcher keineswegs in die Anwendung der Erfindung selbst eingeschlossen werden muss.

An einem Batteriezellen-Element können mit bekannten Techniken, beispielsweise auch durch ein Batterie-Management-System (BMS), Zustandsgrößen des Batteriezellen-Elementes gemessen und/oder bestimmt werden. Beispielsweise können dies eine Temperatur, Stromfluss oder Spannung sein. Die Erfindung ist hier jedoch keineswegs beschränkt. Auch Kombinationen, beispielsweise in Form von rechnerisch ermittelten derivaten Größen, sind möglich und dem Einsatz der Erfindung zugänglich.

Die beanspruchte "erste Zustandsgröße" des Hauptanspruchs stellt eine solche Zustandsgröße dar. Ein umfassender Batteriezellen-Element-Mess-Datensatzes (im Nachfolgenden auch: Batteriezellen-Element-Mess-Datensatzes, ohne den Zusatz "reduziert") kann so beispielsweise für jedes Batteriezellen-Element eines Batteriesystems einen bestimmten Wert oder Messwert (beispielsweise in Form eines konkreten Wertes einer gemessenen Spannung ("Einzelspannung")) enthalten. Für einen Messzeitpunkt liegt so beispielsweise pro Batteriezellen-Element eine gemessene Spannung (bspw. in der Einheit Volt bzw. V) vor.

Selbst bei kleinen Batteriesystemen und moderater temporaler Samplingrate entstehen so enorme Messdatensätze, welche viel Speicher und Bandbreite benötigen würden.

Die Erfindung schafft hier Abhilfe, indem sie für die Anomaliedetektion und/oder -vorhersage nur einen reduzierten Batteriezellen-Element-Mess-Datensatzes benötigt und zum Einsatz bringt. Zudem macht die Erfindung für reduzierte Batteriezellen-Element-Mess-Datensätze besonders bevorzugte Vorschläge im Rahmen von Weiterbildungen der Erfindung.

Vor der Diskussion des allgemeinen Falles eines für den Einsatz der vorliegenden Erfindung geeigneten reduzierten Batteriezellen-Element-Mess-Datensatzes sei ebendieser reduzierte Batteriezellen-Element-Mess-Datensatz zunächst anschaulich anhand eines besonders einfach gewählten Beispiels verdeutlicht. So umfasst der reduzierten Batteriezellen-Element-Mess-Datensatzes in einem Beispiel mit der ersten Zustandsgröße Spannung beispielsweise nur eine maximale Spannung und eine minimale Spannung (von allen unter den Batteriezellen-Elementen ermittelten Spannungswerten), also beispielsweise nur zwei numerische Werte (pro Zeitpunkt). In diesem Beispiel werden also "die Spannung des Batteriezellen-Elements mit der höchsten Spannung" sowie "die Spannung des Batteriezellen-Elements mit der niedrigsten Spannung" bereitgestellt. Die übrigen Spannungs-Messwerte der übrigen Batteriezellen-Elemente werden somit nicht bereitgestellt. Anschaulich gesprochen rühren die beiden Messwerte des reduzierten Batteriezellen-Element-Mess-Datensatzes von zwei Batteriezellen-Elementen des Batteriesystems her. Welche genau dies sind, muss nicht konstant festgelegt sein und kann zudem in der Zeit variieren, beispielsweise da elektrische Spannungen belastungsabhängig fluktuieren (die einzelnen Batteriezellen-Elemente eines Systems stehen also permanent in einem "Auswahlwettbewerb" für den reduzierten Datensatz.) In anderen Worten, von welcher Zelle/welchem Batteriezellen-Element ein im reduzierten Batteriezellen-Element-Mess-Datensatz vorhandener Messwert stammt, kann insbesondere zwischen verschiedenen Zeitpunkten des reduzierten Batteriezellen-Element-Mess-Datensatzes variieren.

Das Kriterium Minimum/Maximum der Spannung sei jedoch an dieser Stelle lediglich als einfaches Beispiel angeführt und die Erfindung ist keineswegs auf derartige reduzierte Batteriezellen-Element-Mess-Datensätze beschränkt, wie im Folgenden weiter erläutert wird.

Der reduzierte Batteriezellen-Element-Mess-Datensatz, welcher für einen Einsatz im Rahmen der Erfindung geeignet ist, umfasst ein erstes, nach einem ersten Kriterium aus der Menge der Messdaten der Batteriezellen-Elemente aus dem Batteriezellen-Element-Mess-Datensatzes, für diesen Zeitpunkt und die genannte erste Zustandsgröße, ausgewähltes Messdatum. Ein solches Kriterium sei beispielsweise als $f_1$ bezeichnet.

Der reduzierte Batteriezellen-Element-Mess-Datensatz, welcher für einen Einsatz im Rahmen der Erfindung geeignet ist, umfasst ferner ein zweites, nach einem zweiten Kriterium aus der Menge der Messdaten der Batteriezellen-Elemente aus dem Batteriezellen-Element-Mess-Datensatzes, für diesen Zeitpunkt und die genannte erste Zustandsgröße, ausgewähltes Messdatum. Ein solches Kriterium sei beispielsweise als $f_2$ bezeichnet.

$f_1$ und $f_2$ sind beispielsweise Kriterien, welche die Zellen mit der minimalen oder maximalen Spannung ($\overline{U}$; sogenannte zweite Zustandsgröße, vgl. Diskussion der bevorzugten Weiterbildungen der vorliegenden Erfindung) selektieren (in diesem Beispiel

$$f_1 = \min_{\overline{U}} \text{ und } f_2 = \max_{\overline{U}}$$

oder andersherum). Es können aber auch andere Kriterien sein.

Die erste Zustandsgröße ($\overline{\overline{U}}$) gibt also das Messdatum an, welches durch einen numerischen Wert im reduzierten Batteriezellen-Element-Mess-Datensatz ausgegeben wird. In einem sehr einfachen Beispiel kann dies ebenfalls die Spannung, z.B. in der Einheit V, (oder beispielsweise Strom, z.B. in der Einheit A) sein.

Die Kriterien $f_1$ und $f_2$ wirken also auf die (allgemeine) erste Zustandsgröße:

$$f_1(\overline{\overline{U}}) \text{ bzw. } f_2(\overline{\overline{U}})$$

Im Folgenden wird dies auch abgekürzt durch:

$$f_{1/2}(\overline{\overline{U}})$$

oder allgemeiner

$$f_n(\overline{\overline{U}}), \, n=1,2,3,\ldots$$

In dem oben diskutierten einfachen Beispiel beziehen sich sowohl die erste Zustandsgröße als auch das Selektionskriterium auf die Spannung, welche an den Batteriezellen-Elementen des Batteriesystems besteht, d.h. in diesem Beispiel $\overline{\overline{U}} = \overline{U} = \text{Spannung}$ des Batteriezellen-Elements (in anderen Worten: erste und zweite Zustandsgröße fallen zusammen auf "Spannung", mehr dazu im Rahmen der Weiterbildungen der Erfindung). Es sei betont, dass diese erfindungsgemäß keineswegs zusammenfallen müssen, sondern dass dies lediglich ein besonders anschauliches und einfach verständliches Beispiel darstellt.

In dem oben diskutierten einfachen Beispiel umfasst der reduzierte Batteriezellen-Element-Mess-Datensatz also

$$\min_{\bar{U}}(\bar{\bar{U}}) \text{ sowie } \max_{\bar{U}}(\bar{\bar{U}})$$

Auf Grundlage dieser in diesem Beispiel zwei Größen (beispielsweise je Zeitpunkt t) erfolgt erfindungsgemäß ein Bestimmen und/oder Vorhersehen einer Anomalie des Batteriesystems. Hierdurch ist die Erfindung besonders ressourcenschonend und effizient. In einem Beispiel, in dem ein Batteriesystem aus 1000 Zellen besteht, werden statt 1000 Zell-Messwerten nur 2 Werte, beispielsweise der momentane Spannungswert der Zelle mit der momentan höchsten aller Spannungen sowie der momentane Spannungswert der Zelle mit der momentan niedrigsten aller Spannungen, übertragen. Das sind 0,5% des ursprünglichen Datenvolumens. Durch die besondere Wahl der Messdaten, welche der reduzierte Batteriezellen-Element-Mess-Datensatz umfasst, sind zudem präzise und verlässliche Vorhersagen möglich.

Dies gilt sowohl für eine minimale Form des reduzierte Batteriezellen-Element-Mess-Datensatzes

$$f_{1/2}(\bar{\bar{U}})$$

als auch allgemeiner für

$$f_n(\bar{\bar{U}}), \ n=1,2,3,4,5,\ldots$$

Es sei betont, dass der (explizite) Schritt des "Reduzierens" eines Batteriezellen-Element-Mess-Datensatzes lediglich einen dem Einsatz der Erfindung vorgelagerten Schritt darstellt. Die Erfindung hat erkannt, dass ein solcher reduzierter Datensatz zu präzisen und verlässlichen Anomalieaussagen zum Batteriesystem in besonderer Weise geeignet ist, dabei Ressourcen schont, und damit ansonsten bisher unzugängliche Ergebnisse der Analyse erstmalig verfügbar macht.

Die Erfindung hat erkannt, dass die reduzierten Batteriezellen-Element-Mess-Datensätze, wie oben beschrieben, ausreichend gut für die Anomaliedetektion und -vorhersage geeignet sind, und in Bezug auf das reduzierte Datenvolumen in besonders guter Weise, durch die gezielte Datenauswahl. Dabei sind die reduzierten Batteriezellen-Element-Mess-Datensätze aufgrund ihres geringeren Datenumfangs um ein Vielfaches kleiner, und ressourcenschonender zu übertragen und weiter zu verarbeiten. Durch die speziell reduzierte Auswahl der Daten sind hierauf besonders zweckmäßige Vorhersagen möglich.

Die Analyse bzw. das Vorhersehen ist wie beschrieben auf Basis des reduzierten Batteriezellen-Element-Mess-Datensatzes möglich. Dies kann beispielsweise auf direkter, d.h. unmittelbarer Basis geschehen, aber auch mittelbar. So kann beispielsweise ein weiterer, auf dem reduzierten Batteriezellen-Element-Mess-Datensatz basierender, Datensatz zur eigentlichen Analyse oder Vorhersage herangezogen werden. Die Nutzung der Erfindung benötigt dann lediglich einen solchen hierauf basierenden Datensatz als Daten-Input.

Die Motivationen für einen solchen weiteren, auf dem reduzierten Batteriezellen-Element-Mess-Datensatz basierenden, Datensatz können vielfältig sein. Auch die Art des "Basierens" ist nicht limitiert. Beispielsweise können zeitliche Verläufe der einzelnen Größen im Datensatz unvollständig sein, und werden dazu beispielsweise interpoliert. Dazu kann beispielsweise der Verlauf einer anderen Größe des Datensatzes herangezogen werden. Dies ist jedoch lediglich ein Beispiel. Im Allgemeinen können sämtliche Größen eines weiteren, auf dem reduzierten Batteriezellen-Element-Mess-Datensatz basierenden, Datensatzes von sämtlichen Größen des reduzierten Batteriezellen-Element-Mess-Datensatzes funktional abhängen, ohne dass es hier Beschränkungen gäbe. Ein weiterer Datensatz oder Batteriezellen-Element-Mess-Datensatz ist also einfach ein hierauf irgendwie basierender Datensatz.

Das Merkmal "zu einem Zeitpunkt" ist funktional auszulegen. Es geht also um Daten, welche für den Fachmann in einem Zeitzusammenhang stehen. Eine wortwörtliche oder enge wortsinngemäße Auslegung ist daher zu vermeiden, und einer technisch motivierten Auslegung der Vorrang einzuräumen, damit sich der Schutzbereich der Erfindung nicht durch minimale und/oder willkürlich Modifikation von Zeitpunkten umgehen lässt. So sind beispielsweise Zeiten bzw. Zeitdifferenzen von weniger als einer Sekunde als nicht geeignet anzusehen, um den Schutzbereich der Erfindung zu verlassen, bevorzugt weniger als 100 ms, abermals bevorzugt weniger als 10 ms, abermals bevorzugt weniger als 1 ms.

So sind insbesondere geringe Zeitpunktdifferenzen bei einem asynchronen Sampling verschiedener Messdaten und/oder Sampling mit verschiedenen Samplingraten nicht dazu geeignet, um diese Daten als "sich nicht auf einen Zeitpunkt beziehend" zu disqualifizieren.

Das Merkmal "zu einem Zeitpunkt" zielt also lediglich auf die generelle Natur der Erfindung ab, sofern diese als Verfahren kontinuierlich und/oder wiederholt in der Zeit fortlaufend betrieben bzw. angewandt wird. Hier werden also beispielsweise immer "aktuelle" Werte verarbeitet, wodurch ein Zeitverlauf entsteht.

Gemäß einer Weiterbildung ist das erste Kriterium respektive zweite Kriterium derart beschaffen, dass ein Batteriezellen-Element aus dem Batteriezellen-Element-Mess-Datensatz ausgewählt wurde, dass die erste Zustandsgröße, unter den Batteriezellen-Elementen des Batteriezellen-Element-Mess-Datensatzes ein erstes respektive zweites Kriterium erfüllt.

In dieser Weiterbildung ist es also die *erste* Zustandsgröße, welche zwei Funktionen übernimmt. Es ist also die erste Zustandsgröße, welche numerisch in dem reduzierten Batteriezellen-Element-Mess-Datensatz wiedergegeben ist, als auch die(selbe) erste Zustandsgröße, auf welche das erste/zweite Kriterium angewandt wird, welches bestimmt, welche (beispielsweise zwei) Batteriezellen-Elemente die ausgewählten Messdaten im reduzierten Batteriezellen-Element-Mess-Datensatz konstituieren.

In einem einfachen Beispiel ist die erste Zustandsgröße eine Spannung. Der reduzierte Batteriezellen-Element-Mess-Datensatz enthält daher zwei Spannungswerte (numerische Wiedergabe), wobei zudem jedoch diese beiden Spannungswerte aus der Gesamtheit der Spannungswerte aller Batteriezellen-Elemente derart *anhand der Spannungswerte selbst* ausgewählt wurden, sodass diese Spannungswerte selbst ein erstes/zweites Kriterium erfüllen.

Lediglich in einem Beispiel ist das erste/zweite Kriterium ein Maximal- bzw. Minimaloperator: Dann wird also die maximale und die minimale Spannung aus der Menge aller Batteriezellen-Elemente ausgewählt, und so ein reduzierter Batteriezellen-Element-Mess-Datensatz aus der maximalen und die minimalen Spannung konstituiert.

Ausgehend von dem allgemeinen Fall

$$f_{1/2}(\overline{\overline{U}}) \text{ bzw. } f_n(\overline{\overline{U}}), n=1,2,3,\ldots$$

abgekürzt als

$$f(\overline{\overline{U}})$$

beschreibt diese Weiterbildung also den Fall

$$f_{\overline{\overline{U}}}(\overline{\overline{U}}).$$

Diese Implementierung ist zudem besonders ressourcenschonend, und nutzt das Potential einer einzelnen Zustandsgröße maximal aus. Die Anomaliedetektion bzw. -vorhersage ist dadurch gleichzeitig recheneffizient und verlässlich.

Gemäß einer Weiterbildung ist das erste Kriterium respektive zweite Kriterium derart beschaffen, dass ein Batteriezellen-Element aus dem Batteriezellen-Element-Mess-Datensatz ausgewählt wurde, dass die erste Zustandsgröße, unter den Batteriezellen-Elementen des Batteriezellen-Element-Mess-Datensatzes maximal respektive minimal ist.

Dies entspricht dem oben bereits als Beispiel angeführten Fall:

$$\min_{\overline{\overline{U}}}(\overline{\overline{U}}) \text{ bzw. } \max_{\overline{\overline{U}}}(\overline{\overline{U}}).$$

Minimum und Maximum sind besonders aussagekräftig, da sich abnormales Verhalten des Batteriesystems besonders häufig in abnormalem Verhalten in diesen Größen niederschlägt.

Gemäß einer Weiterbildung ist das erste Kriterium respektive zweite Kriterium derart beschaffen, dass ein Batteriezellen-Element aus dem Batteriezellen-Element-Mess-Datensatz so ausgewählt wurde, dass eine zweite Zustandsgröße, insbesondere Temperatur, Stromfluss und/oder Spannung und/oder zweite Zustandsgrößen, welche durch Kombinationen hieraus beschrieben sind, unter den Batteriezellen-Elementen des Batteriezellen-Element-Mess-Datensatzes ein erstes respektive zweites Kriterium erfüllt.

In dieser Weiterbildung kommt eine zweite Zustandsgröße als Selektionskriterium für den reduzierten Batteriezellen-Element-Mess-Datensatz zum Einsatz. Dies gibt hohe Flexibilität und bringt hohes Analysepotential mit sich. Die Weiterbildung entspricht dem Fall

$$f_{\overline{U}}(\overline{\overline{U}}).$$

Dabei können $\overline{\overline{U}}$ und $\overline{U}$ im Allgemeinen verschieden sein, oder identisch gewählt sein, d.h. zusammenfallen. Lediglich beispielsweise sind es also Spannung oder Stromstärke, oder Stromstärke und Stromstärke, oder Spannung und Spannung.

Gemäß einer Weiterbildung ist das erste Kriterium respektive zweite Kriterium derart beschaffen, dass ein Batteriezellen-Element aus dem Batteriezellen-Element-Mess-Datensatz ausgewählt wurde, dass eine zweite Zustandsgröße, insbesondere Temperatur, Stromfluss und/oder Spannung und/oder zweite Zustandsgrößen, welche durch Kombinationen hieraus beschrieben sind, unter den Batteriezellen-Elementen des Batteriezellen-Element-Mess-Datensatzes maximal respektive minimal ist.

Die Weiterbildung entspricht also dem Fall

$$\min_{\overline{U}}(\overline{\overline{U}}) \text{ sowie } \max_{\overline{U}}(\overline{\overline{U}})$$

Minimum und Maximum sind besonders aussagekräftig, da sich abnormales Verhalten des Batteriesystems besonders häufig in abnormalem Verhalten in diesen Größen niederschlägt.

Gemäß einer Weiterbildung sind die erste und die zweite Zustandsgröße voneinander verschieden, insbesondere zwei verschiedene aus: Temperatur, Stromfluss und/oder Spannung und/oder Zustandsgröße, welche durch Kombinationen hieraus beschrieben sind.

Dies gibt hohe Flexibilität und bringt hohes Analysepotential mit sich.

Gemäß einer Weiterbildung fallen die erste und die zweite Zustandsgröße zusammen und/oder sind identisch definiert, insbesondere als eines aus: Temperatur, Stromfluss und/oder Spannung und/oder Zustandsgröße, welche durch Kombinationen hieraus beschrieben sind.

Dies ist besonders ressourcenschonend, und maximiert das Datenanalysepotential aus Grundlage einer einzigen Zustandsgröße.

Gemäß einer Weiterbildung ist das erste Kriterium und/oder zweite Kriterium derart beschaffen, dass ein Batteriezellen-Element aus dem Batteriezellen-Element-Mess-Datensatz ausgewählt wurde, dass die zweite Zustandsgröße, unter den Batteriezellen-Elementen des Batteriezellen-Element-Mess-Datensatzes in Bezug auf die übrigen Batteriezellen-Elementen eine oder mehrere der folgenden Bedingungen erfüllt:

- Maximalwert unter den Batteriezellen-Elementen,
- Minimalwert unter den Batteriezellen-Elementen,
- Mittelwert unter den Batteriezellen-Elementen, insbesondere gewichtet, ungewichtet, arithmetisch und/oder geometrisch,
- Median unter den Batteriezellen-Elementen,
- Perzentil unter den Batteriezellen-Elementen, insbesondere vordefiniertes Perzentil.

Diese Werte bzw. Bedingungen bzw. Werte und Zustandsgrößen, die sich rechnerisch daraus ergeben, geben insbesondere in verschieden Arten von Batterieanomalien die notwendigerweise frühzeitigen Erkenntnisse und Einsichten. Es wird zudem eine Flexibilität im Verfahren bereitgestellt, welche besonders gut geeignet ist, um an spezielle Batterietypen und ihr systemeigenes, insbesondere batteriesystemimmanentes, Verhalten besonders anzupassen.

Gemäß einer Weiterbildung umfasst das Verfahren ferner einen Schritt eines Errechnens einer oder mehrerer Kenn- oder Zustandsgrößen für das Batteriesystem, insbesondere eines oder mehrere aus: Widerstand, Impedanz, Kapazität, Gesundheitszustand, State of Health, Ladezustand, State of Charge, Temperatur und/oder Kombinationen hieraus, auf Basis des reduzierten Batteriezellen-Element-Mess-Datensatzes. Die errechneten Größen lassen sich nicht oder nur bedingt echten, physikalisch vorhandenen Batterieelementen zuordnen, da diese Information in der Regel bei der Reduktion ganz oder teilweise verloren geht. Es kann nurmehr von **repräsentativen Größen** gesprochen werden.

So ist beispielsweise eine errechnete Kapazität C1 aus dem reduzierten Batteriezellen-Element-Mess-Datensatz nicht zwangsläufig *einem,* insb. nicht konstant ein und demselben, Batterieelement, zugeordnet bzw. zuordenbar. Vielmehr steht jene Kapazität C1 erfahrungsgemäß repräsentativ und qualitativ oft in einem Zusammenhang mit grundsätzlichen Eigenschaften des Gesamtsystems. Für eine zweite aus derselben Datenbasis errechnete Kapazität C2 gilt entsprechendes.

Der Erfindung zugrunde liegt nun die Erkenntnis, dass insbesondere die zeitliche Veränderung, in Form von Trends, plötzlicher Ereignisse, Veränderungen und Anomalien oder sonstigen Auffälligkeiten, von diesen nunmehr **repräsentativen Größen** indikativ für bevorstehendes unerwünschtes Systemverhalten sein kann. Hierbei kommt es noch nicht - allenfalls erst bei einer optionalen Lösungs- oder Grundsuche - auf eine Zuordenbarkeit an. Allein die Feststellung, dass sich (im Beispiel: C1 und C2) nicht mehr wie erwartet zueinander verhalten, ist indikativ für eine Anomalie.

Durch Nutzung des reduzierten Batteriezellen-Element-Mess-Datensatz als Berechnungsbasis werden technische Ressourcen besonders stark geschont.

Gemäß einer Weiterbildung umfasst das Verfahren ferner ein Vergleichen einer oder mehrerer Kenngrößen oder errechneter Größen, insbesondere besagter repräsentativer Größen, mit einer oder mehrerer Referenzgrößen. Diese Referenzgrößen können beispielsweise aus Erfahrungswerten abgeleitet sein. Vorteilhaft ist auch eine automatische Erkennung von beschriebenen mehr oder weniger plötzlichen Veränderungen; hierzu können beispielsweise errechnete repräsentative Größen oder direkt Werte aus dem Batteriezellen-Element-Mess-Datensatz über einen ersten, langen Zeitraum gemittelt und/oder von Ausreißern befreit werden und - unter der Annahme, dass ein System grundsätzlich funktionsfähig und nicht überwiegend abnormal ist und ein ununterbrochener Betrieb als "Normzustand" gewertet werden kann - das Ergebnis als "ok" definiert werden. Ein zweiter, beispielsweise über einen kürzeren Zeitraum entsprechend ermittelter, Wert wird sodann mit ersterem verglichen. Bei zu hohen und/oder zu schnellen Abweichungen zwischen den Werten kann eine Anomalie erkannt sein.

Die Definition von "lange" und "kurz" ergibt sich für gewöhnlich aus der Anwendung, kann aber beispielsweise mehrere Tage bis viele Wochen (lang) sowie mehrere Minuten bis wenige Wochen (kurz) betragen.

Auch ist eine Mittelung und/oder Ausreißerbereinigung nur ein Weg zur Gewinnung dieser Werte. Auch andere statistische Verfahren und Aggregatoren sind möglich. Möglich sind unter anderem auch Verfahren, welche eines oder mehrere Operatoren beinhalten aus: Größer- und/oder Kleiner-Operator, insbesondere Größer-Gleich- und/oder Keiner-Gleich-Operator, insbesondere bezüglich eines Durchschnittswerts und/oder eines Schwellenwertes, Bilden eines Durchschnittswerts, Trendanalyse, und/oder Detektion von Outlier-Werten.

Gemäß einer Weiterbildung umfasst das Verfahren ferner einen Schritt eines Bereitstellens eines Batteriezellen-Element-Identifikations-Datensatzes, welcher für jedes Datum des Batteriezellen-Element-Mess-Datensatz ein Identifikations- und/oder Zuordnungs-Datum enthält. So enthält beispielsweise der reduzierte Batteriezellen-Element-Mess-Datensatz unter anderem die Spannung des Batterieelements mit der niedrigsten Temperatur. Sodann enthielte der Batteriezellen-Element-Identifikations-Datensatzes unter anderem beispielsweise eine Identifikationsnummer jenes Batteriezellenelements, von dessen Sensor dieser Temperaturwert stammt. Der Batteriezellen-Element-Identifikations-Datensatz kann also geeignet sein, eine Zuordnung der Werte aus dem reduzierten Batteriezellen-Element-Mess-Datensatzes zu zugehörigen Batteriezellen-Elementen des Batteriesystems zu ermöglichen.

Gemäß einer Weiterbildung umfasst das Identifikations- und/oder Zuordnungs-Datum eines oder mehrere aus: eine Zell-ID oder eine Zell-Nummer, eine Information zu einer physikalischen/geometrischen Position, insbesondere ungefähre und/oder genäherte Position, einer Zelle, eine ID einer Gruppe von Zellen und/oder eines logischen Clusters von Zellen.

Gemäß einer Weiterbildung ist das Identifikations- und/oder Zuordnungs-Datum eindeutig innerhalb des Batteriesystems. Gemäß einer Weiterbildung ist das Identifikations- und/oder Zuordnungs-Datum gar global eindeutig, oder kann durch Zuhilfenahme weiterer Informationen - beispielsweise Identifikationskennungen des Batteriesystems selbst - global eindeutig identifiziert werden.

Gemäß einer Weiterbildung ist das Identifikations- und/oder Zuordnungs-Datum nicht eindeutig innerhalb des Batteriesystems.

Gemäß einer Weiterbildung umfasst der Schritt des Bestimmens und/oder Vorhersehens einer Anomalie des Batteriesystems ferner einen Schritt eines Lokalisierens der Anomalie innerhalb des Batteriesystems unter Nutzung des Batteriezellen-Element-Identifikations-Datensatzes. Gemäß einer Weiterbildung basiert das Lokalisieren der Anomalie innerhalb des Batteriesystems darauf, wie häufig ein Identifikations- und/oder Zuordnungs-Datum innerhalb eines Betrachtungszeitraumes auftritt, wobei der Betrachtungszeitraum mindestens ungefähr dem Betrachtungszeitraum der oben beschrieben Vergleiche entspricht. Gemäß einer Weiterbildung ist das Batteriesystem in logische Cluster gruppiert und das Lokalisieren der Anomalie innerhalb des Batteriesystems basiert ferner darauf, wie häufig Identifikations- und/oder Zuordnungs-Daten, welche in einen bestimmten Cluster des Batteriesystems fallen, innerhalb eines Betrachtungszeitraumes auftreten.

Gemäß einer Weiterbildung umfasst der Schritt des Bestimmens und/oder Vorhersehens einer Anomalie des Batteriesystems den Einsatz einer Künstlichen Intelligenz, insbesondere eines Maschinenlern-Modells. Durch den Einsatz von ML-Modellen ist das Verfahren besonders flexibel lernfähig und im Ergebnis präzise. Durch ML können die Effekte modelliert werden, ohne dass Beschränkungen auf abschließende Listen von Effekten vorgenommen werden müssten.

Obwohl einige Aspekte im Rahmen einer Vorrichtung beschrieben wurden, ist es klar, dass diese Aspekte auch eine Beschreibung des entsprechenden Verfahrens darstellen, wobei ein Block oder eine Vorrichtung einem Verfahrensschritt oder einer Funktion eines Verfahrensschritts entspricht. Analog dazu stellen Aspekte, die im Rahmen eines Verfahrensschritts beschrieben werden, auch eine Beschreibung eines entsprechenden Blocks oder Elements oder einer Eigenschaft einer entsprechenden Vorrichtung dar.

Ausführungsbeispiele der Erfindung können in einem Computersystem realisiert werden. Das Computersystem kann eine lokale Computervorrichtung (z.B. Personalcomputer, Laptop, Tablet-Computer oder Mobiltelefon) mit einem oder mehreren Prozessoren und einer oder mehreren Speichervorrichtungen oder kann ein verteiltes Computersystem (z.B. ein Cloud-Computing-System mit einem oder mehreren Prozessoren oder einer oder mehreren Speichervorrichtungen, die an verschiedenen Stellen verteilt sind, zum Beispiel an einem lokalen Client und/oder einer oder mehreren Remote-Server-Farms und/oder Datenzentren) sein. Das Computersystem kann irgendeine Schaltung oder Kombination von Schaltungen umfassen. Bei einem Ausführungsbeispiel kann das Computersystem einen oder mehrere Prozessoren umfassen, die von irgendeinem Typ sein können. Nach hiesigem Gebrauch kann Prozessor irgendein Typ von Rechenschaltung bedeuten, wie beispielsweise, aber nicht beschränkt auf, ein Mikroprozessor, ein Mikrocontroller, ein Mikroprozessor mit komplexem Befehlssatz (CISC), ein Mikroprozessor mit reduziertem Befehlssatz (RISC), ein Sehr-langes-Anweisungswort- (Very Long Instruction Word; VLIW) Mikroprozessor, ein Graphikprozessor, ein digitaler Signalprozessor (DSP), ein Multi-Core-Prozessor, ein feld-programmierbares Gate-Array (FPGA) oder irgendein anderer Typ von Prozessor oder Verarbeitungsschaltung. Andere Typen von Schaltungen, die in dem Computersystem umfasst sein können, können eine speziell angefertigte Schaltung, eine anwendungsspezifische integrierte Schaltung (ASIC) oder Ähnliches, wie beispielsweise eine oder mehrere Schaltungen (z. B. eine Kommunikationsschaltung) zur Verwendung bei drahtlosen Vorrichtungen wie z. B. Mobiltelefonen, Tablet-Computern, Laptop-Computern, Funksprechgeräten und ähnlichen elektronischen Systemen sein. Das Computersystem kann eine oder mehrere Speichervorrichtungen umfassen, die ein oder mehrere Speicherelemente umfassen können, die für die jeweilige Anwendung geeignet sind, wie beispielsweise einen Hauptspeicher in der Form eines Direktzugriffsspeichers (RAM, Random Access Memory), eine oder mehrere Festplatten und/oder ein oder mehrere Laufwerke, die entfernbare Medien, wie beispielsweise CDs, Flash-Speicherkarten, DVD und Ähnliches handhaben. Das Computersystem kann auch eine Anzeigevorrichtung, einen oder mehrere Lautsprecher, und eine Tastatur und/oder Steuerung umfassen, die eine Maus, Trackball, Touchscreen, Stimmerkennungsvorrichtung oder irgendeine andere Vorrichtung umfassen kann, die es einem Systemnutzer erlaubt, Information in das Computersystem einzugeben und Information von demselben zu empfangen.

Einige oder alle Verfahrensschritte können durch (oder unter Verwendung) einer Hardwarevorrichtung ausgeführt werden, wie es zum Beispiel ein Prozessor, ein Mikroprozessor, ein programmierbarer Computer oder eine elektronische Schaltung sein kann. In einigen Ausführungsbeispielen können ein oder mehrere der wichtigsten Verfahrensschritte durch eine solche Vorrichtung ausgeführt werden.

Abhängig von bestimmten Implementierungsanforderungen können Ausführungsbeispiele der Erfindung in Hardware oder Software implementiert werden. Die Implementierung kann mit einem nicht-flüchtigen Speichermedium wie einem digitalen Speichermedium, wie beispielsweise einer Diskette, einer DVD, einem Blu-Ray, einer CD, einem ROM, einem PROM und EPROM, einem EEPROM oder einem FLASH-Speicher, durchgeführt werden, auf dem elektronisch lesbare Steuersignale gespeichert sind, die mit einem programmierbaren Computersystem so zusammenwirken (oder zusammenwirken können), dass das jeweilige Verfahren durchgeführt wird. Daher kann das digitale Speichermedium computerlesbar sein.

Einige Ausführungsbeispiele gemäß der Erfindung umfassen einen Datenträger mit elektronisch lesbaren Steuersignalen, die mit einem programmierbaren Computersystem zusammenwirken können, so dass eines der hierin beschriebenen Verfahren durchgeführt wird.

Im Allgemeinen können Ausführungsbeispiele der vorliegenden Erfindung als Computerprogrammprodukt mit einem Programmcode implementiert werden, wobei der Programmcode für die Ausführung eines der Verfahren wirksam ist, wenn das Computerprogrammprodukt auf einem Computer läuft. Der Programmcode kann beispielsweise auf einem maschinenlesbaren Träger gespeichert werden.

Weitere Ausführungsbeispiele umfassen das Computerprogramm zur Durchführung eines der hierin beschriebenen Verfahren, das auf einem maschinenlesbaren Träger gespeichert ist.

Mit anderen Worten, ein Ausführungsbeispiel der vorliegenden Erfindung ist daher ein Computerprogramm mit einem Programmcode zur Durchführung eines der hierin beschriebenen Verfahren, wenn das Computerprogramm auf einem Computer läuft.

Ein weiteres Ausführungsbeispiel der vorliegenden Erfindung ist daher ein Speichermedium (oder ein Datenträger oder ein computerlesbares Medium), das ein darauf gespeichertes Computerprogramm zum Ausführen eines der hierin beschriebenen Verfahren umfasst, wenn es von einem Prozessor ausgeführt wird. Der Datenträger, das digitale Speichermedium oder das aufgezeichnete Medium sind in der Regel greifbar und/oder nicht übergangslos. Eine weiteres Ausführungsbeispiel der vorliegenden Erfindung ist eine Vorrichtung, wie hierin beschrieben, die einen Prozessor und das Speichermedium umfasst.

Ein weiteres Ausführungsbeispiel der Erfindung ist daher ein Datenstrom oder eine Signalfolge, die das Computerprogramm zur Durchführung eines der hierin beschriebenen Verfahren darstellt. Der Datenstrom oder die Signalfolge kann beispielsweise so konfiguriert werden, dass sie über eine Datenkommunikationsverbindung, beispielsweise über das Internet, übertragen werden.

Ein weiteres Ausführungsbeispiel umfasst ein Verarbeitungsmittel, zum Beispiel einen Computer oder eine programmierbare Logikvorrichtung, das konfiguriert oder angepasst ist, um eines der hierin beschriebenen Verfahren auszuführen.

Ein weiteres Ausführungsbeispiel umfasst einen Computer, auf dem das Computerprogramm zum Ausführen eines der hierin beschriebenen Verfahren installiert ist.

Ein weiteres Ausführungsbeispiel gemäß der Erfindung umfasst eine Vorrichtung oder ein System, das konfiguriert ist, um (zum Beispiel elektronisch oder optisch) ein Computerprogramm zum Ausführen eines der hierin beschriebenen Verfahren an einen Empfänger zu übertragen. Der Empfänger kann beispielsweise ein Computer, eine mobile Vorrichtung, eine Speichervorrichtung oder dergleichen sein. Die Vorrichtung oder das System kann beispielsweise einen Dateiserver zum Übertragen des Computerprogramms an den Empfänger umfassen.

In einigen Ausführungsbeispielen kann eine programmierbare logische Vorrichtung (z.B. eine feldprogrammierbare Gatteranordnung, FPGA) verwendet werden, um einige oder alle Funktionalitäten der hierin beschriebenen Verfahren auszuführen. In einigen Ausführungsbeispielen kann eine feldprogrammierbare Gatteranordnung mit einem Mikroprozessor zusammenarbeiten, um eines der hierin beschriebenen Verfahren durchzuführen. Im Allgemeinen werden die Verfahren vorzugsweise von jedem Hardwaregerät durchgeführt.

Ausführungsbeispiele können auf dem Verwenden einer Künstlichen Intelligenz, insbesondere eines Maschinenlern-Modells oder Maschinenlern-Algorithmus, basieren. Maschinelles Lernen kann sich auf Algorithmen und statistische Modelle beziehen, die Computersysteme verwenden können, um eine bestimmte Aufgabe ohne Verwendung expliziter Anweisungen auszuführen, anstatt sich auf Modelle und Inferenz zu verlassen. Beim maschinellen Lernen kann beispielsweise anstatt einer auf Regeln basierenden Transformation von Daten, eine Transformation von Daten verwendet werden, die aus einer Analyse von Verlaufs- und/oder Trainings-Daten hergeleitet werden kann. Beispielsweise kann der Inhalt von Bildern unter Verwendung eines Maschinenlern-Modells oder unter Verwendung eines Maschinenlern-Algorithmus analysiert werden. Damit das Maschinenlern-Modell den Inhalt eines Bildes analysieren kann, kann das Maschinenlern-Modell unter Verwendung von Trainingsbildern als Eingabe und Trainingsinhaltsinformation als Ausgabe trainiert werden. Durch Trainieren des Maschinenlern-Modells mit einer großen Anzahl von Trainingsbildern und/oder Trainingssequenzen (z. B. Wörtern oder Sätzen) und zugeordneter Trainingsinhaltsinformation (z. B. Kennzeichnungen oder Anmerkungen) "lernt" das Maschinenlern-Modell, den Inhalt der Bilder zu erkennen, sodass der Inhalt von Bildern, die in den Trainingsdaten nicht umfasst sind, unter Verwendung des Maschinenlern-Modells erkannt werden kann. Das gleiche Prinzip kann für andere Arten von Sensordaten ebenfalls verwendet werden: Durch Trainieren eines Maschinenlern-Modells unter Verwendung von Trainingssensordaten und einer erwünschten Ausgabe "lernt" das Maschinenlern-Modell eine Umwandlung zwischen den Sensordaten und der Ausgabe, was verwendet werden kann, um eine Ausgabe basierend auf an das Maschinenlern-Modell bereitgestellten Nicht-Trainings-Sensordaten bereitzustellen. Die bereitgestellten Daten (z.B. Sensordaten, Metadaten und/oder Bilddaten) können vorverarbeitet werden, um einen Merkmalsvektor zu erhalten, welcher als Eingang für das Maschinenlern-Modell verwendet wird.

Maschinenlern-Modelle können unter Verwendung von Trainingseingabedaten trainiert werden. Die oben angeführten Beispiele verwenden ein Trainingsverfahren, das "Supervised Learning" genannt wird. Beim Supervised Learning wird das Maschinenlern-Modell unter Verwendung einer Mehrzahl von Trainingsabtastwerten trainiert, wobei jeder Abtastwert eine Mehrzahl von Eingabedatenwerten und eine Mehrzahl von erwünschten Ausgabewerten, d. h. jedem Trainingsabtastwert ist ein erwünschter Ausgabewert zugeordnet, umfassen kann. Durch Angeben sowohl von Trainingsabtastwerten als auch erwünschten Ausgabewerten "lernt" das Maschinenlern-Modell, welcher Ausgabewert basierend auf einem Eingabeabtastwert, der ähnlich zu den während des Trainings bereitgestellten Abtastwerten ist, bereitzustellen ist. Neben dem Supervised Learning kann auch Semi-Supervised Learning verwendet werden. Beim Semi-Supervised Learning fehlt einigen der Trainingsabtastwerte ein erwünschter Ausgabewert. Supervised Learning kann auf einem Supervised Learning-Algorithmus basieren (z. B. einem Klassifizierungsalgorithmus, einem Regressionsalgorithmus oder einem Ähnlichkeitslernen-Algorithmus). Klassifizierungsalgorithmen können verwendet werden, wenn die Ausgaben auf eine begrenzte Menge von Werten (kategorische Variablen) beschränkt sind, d. h. die Eingabe ist als einer aus dem begrenzten Satz von Werten klassifiziert. Regressionsalgorithmen können verwendet werden, wenn die Ausgaben irgendeinen Zahlenwert (innerhalb eines Bereichs) ausweisen. Ähnlichkeitslernen-Algorithmen können sowohl Klassifizierungs- als auch Regressionsalgorithmen ähnlich sein, basieren aber auf dem Lernen aus Beispielen unter Verwendung einer Ähnlichkeitsfunktion, die misst, wie ähnlich oder verwandt zwei Objekte sind. Neben dem Supervised Learning oder Semi-Supervised Learning kann Unsupervised Learning verwendet werden, um das Maschinenlern-Modell zu trainieren. Beim Unsupervised Learning werden möglicherweise (nur) Eingabedaten bereitgestellt und ein Unsupervised Learning-Algorithmus kann verwendet werden, um eine Struktur in den Eingabedaten zu finden (z. B. durch Gruppieren oder Clustern der Eingabedaten, Finden von Gemeinsamkeiten in den Daten). Clustern ist die Zuweisung von Eingabedaten, die eine Mehrzahl von Eingabewerten umfassen, in Teilmengen (Cluster), sodass Eingabewerte innerhalb desselben Clusters gemäß einem oder mehreren (vordefinierten) Ähnlichkeitskriterien ähnlich sind, während sie Eingabewerten, die in anderen Clustern umfasst sind, unähnlich sind.

Verstärkendes Lernen ist eine dritte Gruppe von Maschinenlern-Algorithmen. Anders ausgedrückt, verstärkendes Lernen kann verwendet werden, um das Maschinenlern-Modell zu trainieren. Beim verstärkenden Lernen werden ein oder mehrere Software-Akteure (sogenannte "Software Agents") trainiert, um Handlungen in einer Umgebung vorzunehmen. Basierend auf den vorgenommenen Handlungen wird eine Belohnung berechnet. Verstärkendes Lernen basiert auf dem Trainieren des einen oder der mehreren Software Agents, um die Handlungen auszuwählen, derart, dass die kumulative Belohnung erhöht wird, was zu Software Agents führt, die in der Aufgabe, die ihnen gegeben wird, besser werden (wie durch steigende Belohnungen nachgewiesen).

Ferner können einige Techniken auf einige der Maschinenlern-Algorithmen angewandt werden. Zum Beispiel kann Feature Learning verwendet werden. Anders ausgedrückt, das Maschinenlern-Modell kann zumindest teilweise unter Verwendung von Feature Learning trainiert werden, und/oder der Maschinenlern-Algorithmus kann eine Feature Learning-Komponente umfassen. Feature Learning-Algorithmen, die Representation Learning-Algorithmen genannt werden, können die Information in ihrer Eingabe erhalten, sie aber derart transformieren, dass sie nützlich wird, häufig als Vorverarbeitungsstufe vor dem Ausführen der Klassifizierung oder dem Vorhersagen. Feature Learning kann beispielsweise auf einer Hauptkomponenten-Analyse oder Cluster-Analyse basieren.

Bei einigen Beispielen kann eine Anomaliedetektion (d. h. Ausreißer-Detektion) verwendet werden, die darauf abzielt, eine Identifizierung von Eingabewerten bereitzustellen, die Verdacht erregen, da sie sich erheblich von der Mehrheit von Eingabe- und Trainingsdaten unterscheiden. Anders ausgedrückt, das Maschinenlern-Modell kann zumindest teilweise unter Verwendung von Anomaliedetektion trainiert werden, und/oder der Maschinenlern-Algorithmus kann eine Anomaliedetektions-Komponente umfassen.

Bei einigen Beispielen kann der Maschinenlern-Algorithmus einen Entscheidungsbaum als Vorhersagemodell verwenden. Anders ausgedrückt, das Maschinenlern-Modell kann auf einem Entscheidungsbaum basieren. Bei einem Entscheidungsbaum können die Beobachtungen zu einem Gegenstand (z. B. einer Menge von Eingabewerten) durch die Zweige des Entscheidungsbaums dargestellt werden, und ein Ausgabewert, der dem Gegenstand entspricht, kann durch die Blätter des Entscheidungsbaums dargestellt werden. Entscheidungsbäume können sowohl diskrete Werte als auch fortlaufende Werte als Ausgabewerte unterstützen. Wenn diskrete Werte verwendet werden, kann der Entscheidungsbaum als Klassifizierungsbaum bezeichnet werden, wenn fortlaufende Werte verwendet werden, kann der Entscheidungsbaum als Regressionsbaum bezeichnet werden.

Assoziationsregeln sind eine weitere Technik, die bei Maschinenlern-Algorithmen verwendet werden kann. Anders ausgedrückt, das Maschinenlern-Modell kann auf einer oder mehreren Assoziationsregeln basieren. Assoziationsregeln werden erstellt, indem Verhältnisse zwischen Variablen bei großen Datenmengen identifiziert werden. Der Maschinenlern-Algorithmus kann eine oder mehrere Verhältnisregeln identifizieren und/oder nutzen, die das Wissen darstellen, dass aus den Daten hergeleitet ist. Die Regeln können z. B. verwendet werden, um das Wissen zu speichern, zu manipulieren oder anzuwenden.

Maschinenlern-Algorithmen basieren normalerweise auf einem Maschinenlern-Modell. Anders ausgedrückt, der Begriff "Maschinenlern-Algorithmus" kann einen Satz von Anweisungen bezeichnen, die verwendet werden können, um ein Maschinenlern-Modell zu erstellen, zu trainieren oder zu verwenden. Der Begriff "Maschinenlern-Modell" kann eine Datenstruktur und/oder einen Satz von Regeln bezeichnen, die/der das erlernte Wissen darstellt (z. B. basierend auf dem durch den Maschinenlern-Algorithmus ausgeführten Training). Bei Ausführungsbeispielen kann die Verwendung eines Maschinenlern-Algorithmus die Verwendung eines zugrundeliegenden Maschinenlern-Modells (oder einer Mehrzahl von zugrundeliegenden Maschinenlern-Modellen) implizieren. Die Verwendung eines Maschinenlern-Modells kann implizieren, dass das Maschinenlern-Modell und/oder die Datenstruktur/der Satz von Regeln, welche das Maschinenlern-Modell ist/sind, durch einen Maschinenlern-Algorithmus trainiert wird.

Beispielsweise kann das Maschinenlern-Modell ein künstliches neuronales Netz (ANN; artificial neural network) sein. ANNs sind Systeme, die durch biologische neuronale Netze inspiriert sind, wie sie in einer Netzhaut oder einem Gehirn zu finden sind. ANNs umfassen eine Mehrzahl von zwischenverbundenen Knoten und eine Mehrzahl von Verbindungen, sogenannte Kanten (edges), zwischen den Knoten. Es gibt normalerweise drei Knotentypen, Eingabeknoten, die Eingabewerte empfangen, versteckte Knoten, die (nur) mit anderen Knoten verbunden sind, und Ausgabeknoten, die Ausgabewerte bereitstellen. Jeder Knoten kann ein künstliches Neuron darstellen. Jede Kante kann Information senden, von einem Knoten zum anderen. Die Ausgabe eines Knoten kann als eine (nichtlineare) Funktion der Eingaben definiert sein (z.B. der Summe seiner Eingaben). Die Eingaben eines Knoten können in der Funktion basierend auf einem "Gewicht" der Kante oder des Knoten, der die Eingabe bereitstellt, verwendet werden. Das Gewicht von Knoten und/oder von Kanten kann in dem Lernprozess angepasst werden. Anders ausgedrückt, das Training eines künstlichen neuronalen Netzes kann ein Anpassen der Gewichte der Knoten und/oder Kanten des künstlichen neuronalen Netzes umfassen, d. h. um eine erwünschte Ausgabe für eine bestimmte Eingabe zu erreichen.

Alternativ kann das Maschinenlern-Modell eine Support-Vector-Machine, ein Random-Forest-Modell oder ein Gradient-Boosting-Modell sein. Support Vector Machines (d. h. Stützvektornetze) sind Supervised Learning-Modelle mit zugeordneten Lernalgorithmen, die verwendet werden können, um Daten zu analysieren (z. B. in einer Klassifizierungs- oder Regressionsanalyse). Support Vector Machines können durch Bereitstellen einer Eingabe mit einer Mehrzahl von Trainingseingabewerten, die zu einer von zwei Kategorien gehören, trainiert werden. Die Support Vector Machine kann trainiert werden, um einer der beiden Kategorien einen neuen Eingabewert zuzuweisen. Alternativ kann das Maschinenlern-Modell ein bayessches Netz sein, das ein probabilistisches gerichtetes azyklisches graphisches Modell ist. Ein bayessches Netz kann einen Satz von Zufallsvariablen und ihre bedingten Abhängigkeiten unter Verwendung eines gerichteten azyklischen Graphen darstellen. Alternativ kann das Maschinenlern-Modell auf einem genetischen Algorithmus basieren, der ein Suchalgorithmus und heuristische Technik ist, die den Prozess der natürlichen Selektion imitiert.

**Figurenliste**

Die vorliegende Erfindung wird nachfolgend anhand der in den schematischen Figuren der Zeichnungen angegebenen Ausführungsbeispiele näher erläutert. Es zeigen dabei:

Fig. 1 eine schematische beispielhafte Darstellung eines Kraftfahrzeuges mit einer elektrischen Batterie, hier beispielhaft dargestellt an einer Ladeeinrichtung (Ladesäule/Ladestation),

Fig. 2 eine schematische Darstellung eines Kraftfahrzeuges mit einer elektrischen Batterie mit Zwischenkreis, sonstiges Zwischenkomponenten und Impedanzen,

Fig. 3 eine schematische Darstellung eines beispielhaften Batteriesystems,

Fig. 4 eine weitere schematische Darstellung eines beispielhaften Batteriesystems,

Fig. 5 eine schematische Darstellung eines beispielhaften Batteriesystems geeignet zur Anwendung der vorliegenden Erfindung, im Rahmen einer ersten Ausführungsform, zur Verdeutlichung der Konzepte des Batteriezellen-Element-Mess-Datensatzes sowie des reduzierten Batteriezellen-Element-Mess-Datensatzes,

Fig. 6 eine schematische Darstellung eines beispielhaften Batteriesystems geeignet zur Anwendung der vorliegenden Erfindung, im Rahmen einer ersten Ausführungsform, zur weiteren Verdeutlichung des Konzeptes des reduzierten Batteriezellen-Element-Mess-Datensatzes,

Fig. 7 eine schematische Darstellung eines beispielhaften Batteriesystems geeignet zur Anwendung der vorliegenden Erfindung, im Rahmen einer zweiten beispielhaften Ausführungsform, zur weiteren Verdeutlichung des Konzeptes des reduzierten Batteriezellen-Element-Mess-Datensatzes,

Fig. 8 eine schematische Darstellung eines beispielhaften Batteriesystems geeignet zur Anwendung der vorliegenden Erfindung, im Rahmen einer Ausführungsform, zur weiteren beispielhaften Verdeutlichung des Konzeptes eines Batteriezellen-Element-Identifikations-Datensatzes,

Fig. 9 eine schematische Darstellung eines beispielhaften Batteriesystems mit Batteriezellen-Elementen, welche Gruppierungen und/oder Cluster von Batteriezellen bzw.

Batteriezellen-Elementen in Form von Batteriezellen-(Sub-)Elementen umfassen,

Fig. 10 eine weitere schematische Darstellung eines weiteren beispielhaften Batteriesystems mit Batteriezellen-Elementen, welche Gruppierungen und/oder Cluster von Batteriezellen bzw. Batteriezellen-Elementen in Form von Batteriezellen-(Sub-)Elementen umfassen,

Fig. 11 ein Struktur- bzw. Ablaufdiagramm zu einer Ausführungsform der vorliegenden Erfindung,

Fig. 12 eine schematische eines reduzierten Batteriezellen-Element-Mess-Datensatzes sowie eines weiteren hierauf basierenden Datensatzes gemäß einer Ausführungsform der vorliegenden Erfindung.

In allen Figuren sind gleiche bzw. funktionsgleiche Elemente und Vorrichtungen - sofern nichts anderes angegeben ist - mit denselben Bezugszeichen versehen worden.

**Beschreibung der Zeichnungen**

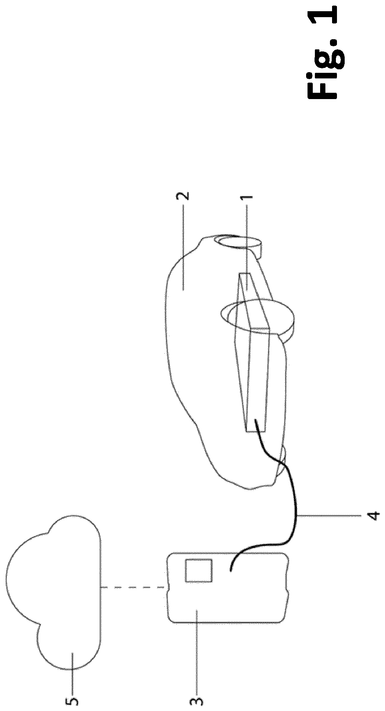

Die Figur 1 zeigt eine schematische beispielhafte Darstellung eines Kraftfahrzeuges mit einer elektrischen Batterie, hier beispielhaft dargestellt an einer Ladeeinrichtung (Ladesäule/Ladestation). Diese Darstellung ist keineswegs beschränkend und zeigt lediglich eine von vielen möglichen beispielhaften Einsatzmöglichkeiten im Zusammenhang mit der vorliegenden Erfindung.

Ein Fahrzeug 2 wird beispielsweise elektrisch betrieben mit der Energie eines Fahrzeug-Energiespeichers 1. Der Fahrzeug-Energiespeicher umfasst zahlreiche Batteriezellen. Diese können parallel und/oder seriell verschaltet sein. Solche Zellen als auch Gruppen solcher Zellen können Batteriezellen-Elemente im Sinne der Erfindung bilden bzw. darstellen. An den oder in unmittelbarer Entfernung der Zellen und/oder Batteriezellen-Elementen können lokal durch Sensoren Messwerte in Bezug auf die Zellen bzw. Batteriezellen-Elemente abgenommen werden. Beispielsweise wird so die Zustandsgröße "Spannung" eines Batteriezellen-Elementes, oder die Zustandsgröße "Temperatur", bestimmt.

In der Darstellung wird die Batterie über ein Ladekabel 4 mit einer Ladeeinrichtung 3 geladen. Die Ladeeinrichtung 3 kommuniziert beispielsweise mit einem Cloud-Server 5.

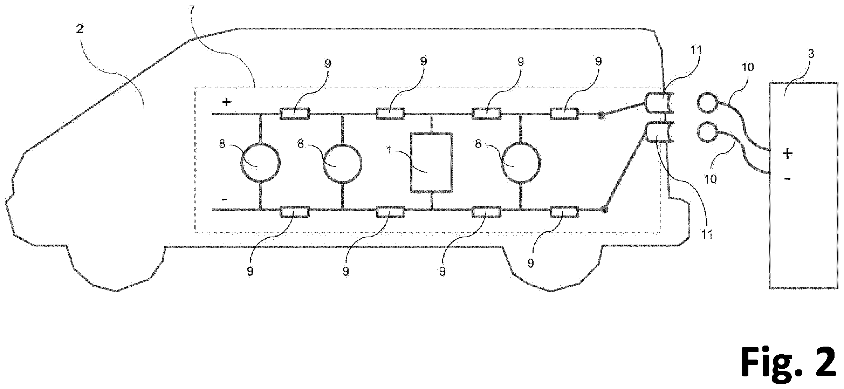

Die Figur 2 zeigt eine schematische Darstellung eines Kraftfahrzeuges mit einer elektrischen Batterie 1 mit Zwischenkreis 7, sonstiges Zwischenkomponenten 8 und Impedanzen 9.

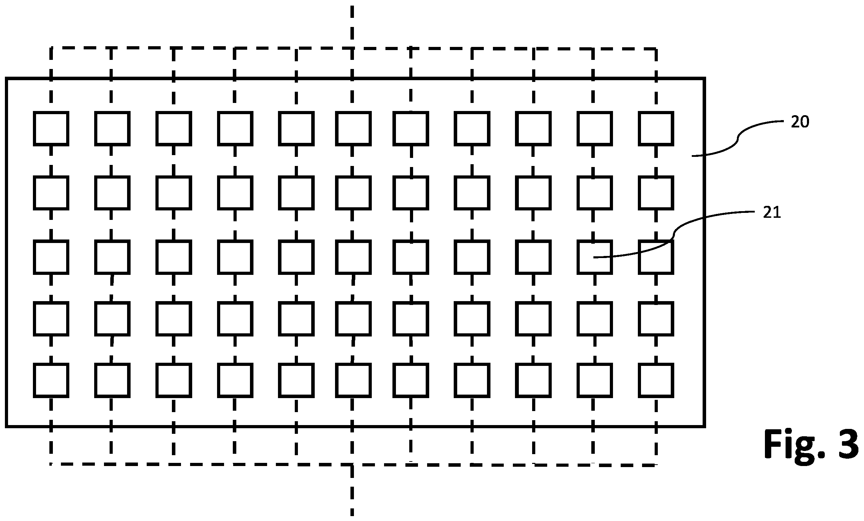

Die Figur 3 zeigt eine schematische Darstellung eines beispielhaften Batteriesystems, welches geeignet ist für einen Einsatz der vorliegenden Erfindung. Es kann, muss sich aber nicht, um einen Fahrzeug-Energiespeicher handeln. Ein Batteriesystem 20 kann mehrere Batteriezellen 21 aufweisen. Bei den Batteriezellen kann es sich, muss sich aber keineswegs um Elementarzellen handeln. Die gestrichelten Linien sind beispielhafte elektrische Leitungen. Andere Verschaltungen der Zellen sind denkbar, umfassend sowohl parallele als auch serielle Verschaltungstopologien. Verschiedene Messgeräte und/oder - strukturen (nicht eingezeichnet) können an den Batteriezellen-Elementen funktionell vorgesehen sein. Beispielsweise kann Temperatursensorik zur Temperaturerfassung (nicht eingezeichnet) vorhanden sein.

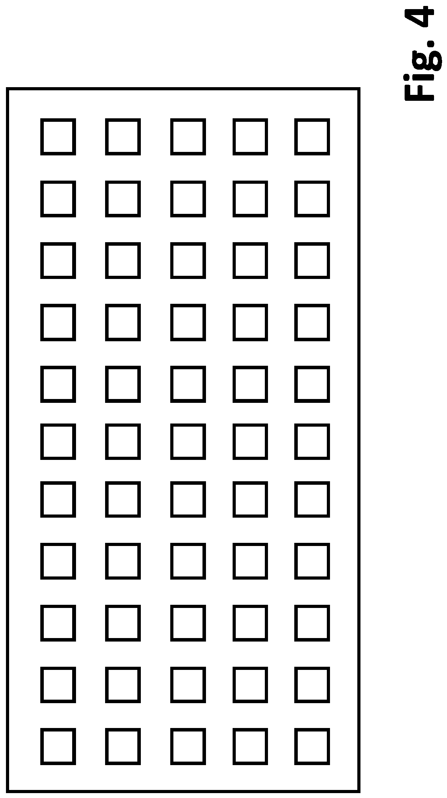

Die Figur 4 zeigt eine weitere schematische Darstellung eines beispielhaften Batteriesystems. Dieses Batteriesystem kann beispielsweise dem Batteriesystem der Figur 3 entsprechen, wobei die Übersichtlichkeit durch Ausblendung einiger Elemente erhöht wurde.

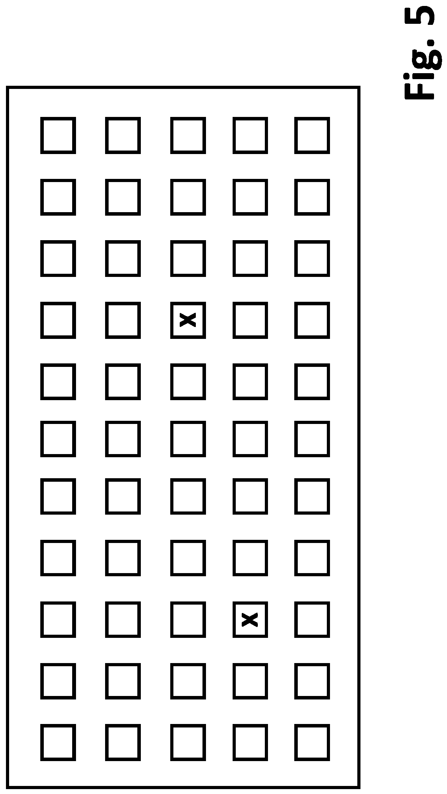

Die Figur 5 zeigt eine schematische Darstellung eines beispielhaften Batteriesystems geeignet zur Anwendung der vorliegenden Erfindung, im Rahmen einer ersten Ausführungsform, zur Verdeutlichung der Konzepte des Batteriezellen-Element-Mess-Datensatzes sowie des reduzierten Batteriezellen-Element-Mess-Datensatzes.

In der Figur 5 ist das beispielhafte Batteriesystem zu einem bestimmten Zeitpunkt dargestellt. Zwei Batteriezellen-Elemente sind durch x markiert. Diese beiden Batteriezellen-Elemente konstituieren beispielsweise, zu diesem fotographischen Zeitpunkt, die Grundlage für einen reduzierten Batteriezellen-Element-Mess-Datensatz.

Die x markieren also ein erstes und ein zweites ausgewähltes Messdatum.

Beispielsweise wurde eine dieser beiden Zellen nach einem ersten Kriterium und die andere nach einem zweiten Kriterium ausgewählt (z.B. Minimum + Maximum (einer zweiten Zustandsgröße), beispielsweise Minimum + Maximum einer Stromstärke, Spannung oder Temperatur). Es sind jedoch ebenso andere Kriterien denkbar, welche nicht unmittelbar mit einer (derartigen zweiten) Zustandsgröße unmittelbar zusammenhängen müssen.

Das Messdatum selbst liegt jeweils für eine erste Zustandsgröße vor. Beispielsweise ist diese Zustandsgröße Spannung. Dann umfasst der reduzierte Batteriezellen-Element-Mess-Datensatz zwei Spannungswerte, nämlich die Spannungswerte der beiden ausgewählten (mit x markierten) Batteriezellen-Elemente.

Die erste und zweite Zustandsgröße können zusammenfallen, müssen dies aber nicht.

In einem einfachen Beispiel fallen erste und zweite Zustandsgröße beide zusammen auf "Spannung". Dann wird, in einem Beispiel mit Minimum und Maximum, die minimale Spannung und die maximale Spannung (aus der Gruppe der Batteriezellen-Elemente) als reduzierter Batteriezellen-Element-Mess-Datensatz genutzt. (In logischer Hinsicht: es wird das Batteriezellen-Element mit der minimalen Spannung ausgewählt, von diesem wird der Spannungswert genommen; es wird das Batteriezellen-Element mit der maximalen Spannung ausgewählt, von diesem wird ebenso der Spannungswert genommen; die beiden Spannungswerte bilden ein einfaches, aber kein sehr allgemeines Beispiel für einen reduzierten Batteriezellen-Element-Mess-Datensatz).

In einem weiteren Beispiel werden drei Batteriezellen-Elemente für den reduzierten Batteriezellen-Element-Mess-Datensatz ausgewählt. Beispielsweise kommen Minimum, Maximum und eine Art Durchschnitts-/Mittelwert (Durchschnitt, Median, gewichteter Durchschnitt, etc.) einer zweiten Zustandsgröße als Auswahlkriterien der datensatzkonstituierenden Batteriezellen-Elemente zum Einsatz.

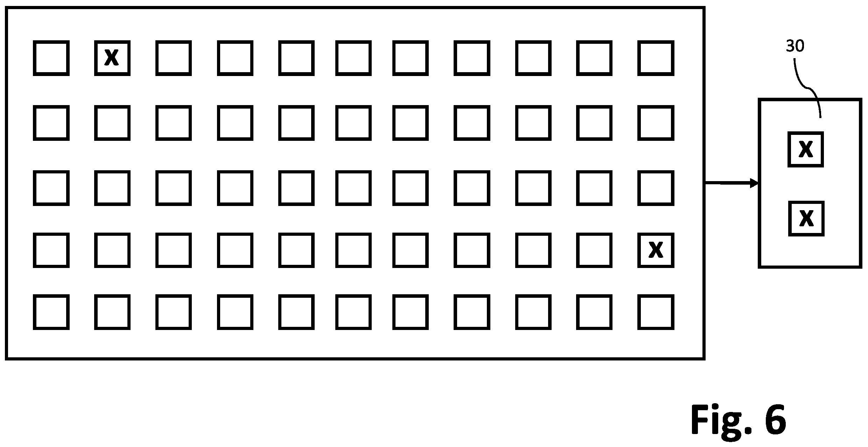

Die Figur 6 zeigt eine schematische Darstellung eines beispielhaften Batteriesystems geeignet zur Anwendung der vorliegenden Erfindung, im Rahmen einer ersten Ausführungsform, zur weiteren Verdeutlichung des Konzeptes des reduzierten Batteriezellen-Element-Mess-Datensatzes.

Dies ist beispielsweise das Batteriesystem der Figur 5 zu einem anderen Zeitpunkt. Wie im Vergleich mit der Figur 5 erkennbar ist, sind es nun andere Batteriezellen-Elemente, welche nach den Kriterien ausgewählt sind. Die Auswahl kann im zeitlichen Verlauf also springen.

In einem einfachen Beispiel fluktuieren die Spannungswerte permanent im zeitlichen Verlauf. Das Batteriezellen-Element mit der niedrigsten Spannung und das mit der höchsten Spannung ist daher häufig ein anderes (als zu einem anderen Zeitpunkt).

Unabhängig hiervon bilden die (zu einem jeweiligen Zeitpunkt) jeweils ausgewählten Daten einen beispielhaften reduzierten Batteriezellen-Element-Mess-Datensatz 30 (zu dem entsprechenden Zeitpunkt).

In anderen Worten können die Daten des reduzierten Batteriezellen-Element-Mess-Datensatz 30 im zeitlichen Verlauf durchaus von sämtlichen unterschiedlichen Batteriezellen-Elementen des Batteriesystems herrühren, da diese keineswegs fest ausgewählt sind, sondern "springen".

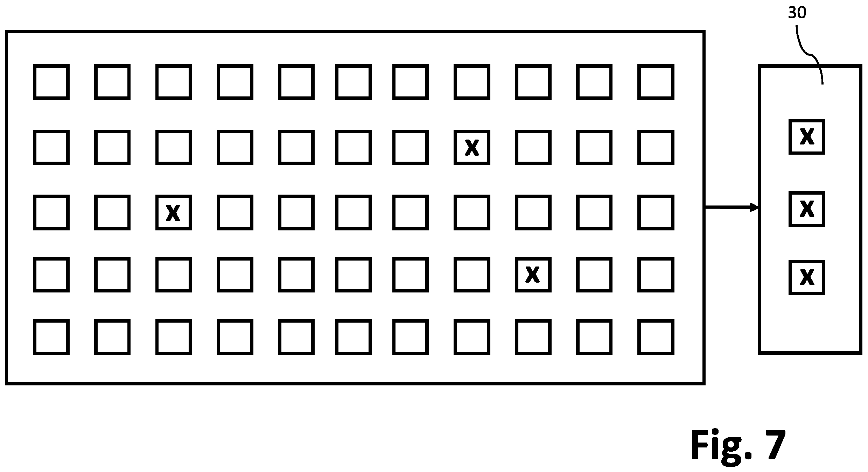

Die Figur 7 zeigt eine schematische Darstellung eines beispielhaften Batteriesystems geeignet zur Anwendung der vorliegenden Erfindung, im Rahmen einer zweiten beispielhaften Ausführungsform, zur weiteren Verdeutlichung des Konzeptes des reduzierten Batteriezellen-Element-Mess-Datensatzes.

In diesem Beispiel wurden nun drei Batteriezellen-Elemente für den reduzierten Batteriezellen-Element-Mess-Datensatz ausgewählt. Beispielsweise kommen Minimum, Maximum und ein Mittelwert (average) einer zweiten Zustandsgröße als Auswahlkriterien der datensatzkonstituierenden Batteriezellen-Elemente zum Einsatz.

Der entsprechende reduzierte Batteriezellen-Element-Mess-Datensatz 30 umfasst so (für einem bestimmten Zeitpunkt) drei Datenelemente/Messdaten.

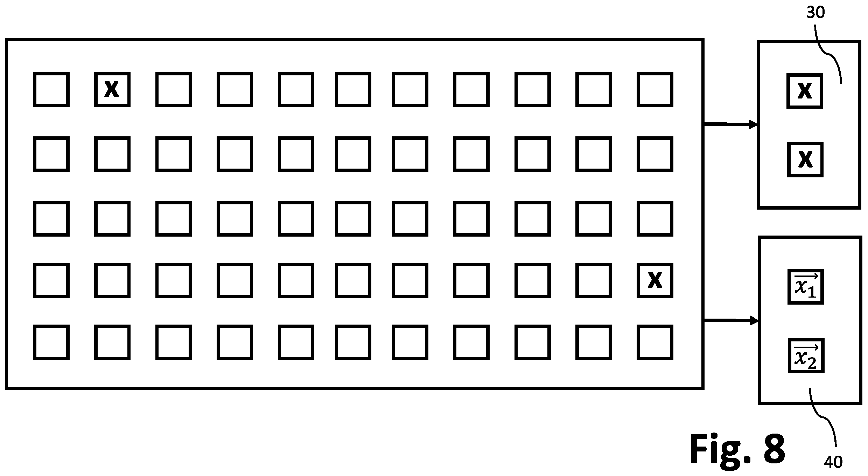

Die Figur 8 zeigt eine schematische Darstellung eines beispielhaften Batteriesystems geeignet zur Anwendung der vorliegenden Erfindung, im Rahmen einer Ausführungsform, zur weiteren beispielhaften Verdeutlichung des Konzeptes eines Batteriezellen-Element-Identifikations-Datensatzes.

Zusätzlich zu dem reduzierten Batteriezellen-Element-Mess-Datensatz 30 wird in diesem Beispiel ein Batteriezellen-Element-Identifikations-Datensatz 40 bereitgestellt.

Vereinfacht gesagt erlaubt der Batteriezellen-Element-Identifikations-Datensatz 40, für einen bestimmten Zeitpunkt, die Batteriezellen-Elemente, deren Zustandsgrößen den reduzierten Batteriezellen-Element-Mess-Datensatz (zu diesem Zeitpunkt) konstituieren, im Batteriesystem zu verorten.

So kann, sofern es einen Batteriezellen-Element-Identifikations-Datensatz 40 gibt, mittels dieses Datensatzes eine entsprechende Position insbesondere nachträglich rekonstruiert werden.

In einem sehr einfachen Beispiel kann es sich bei den Elementen des Batteriezellen-Element-Identifikations-Datensatz 40 um Vektoren handeln. Beispielsweise wird so als Vektor $x_1$ ein Minimalwert an einer Position (0,1) verortet und ein Maximalwert als Vektor $x_2$ an einer Position (3,10) (Koordinatenursprung oben links in der Figur, natürliche Zahlen einschließlich 0). Dieses Beispiel ist jedoch lediglich schematisch und der Anschaulichkeit erwähnt und keineswegs limitierend.

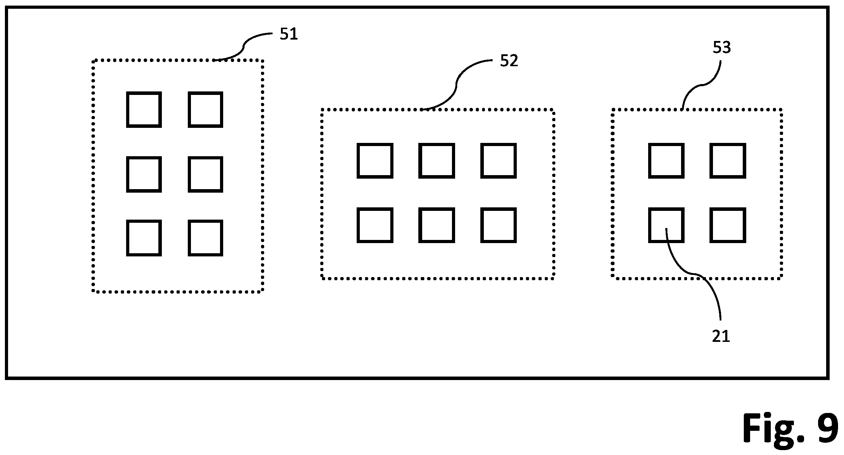

Die Figur 9 zeigt eine schematische Darstellung eines beispielhaften Batteriesystems mit Batteriezellen-Elementen, welche Gruppierungen und/oder Cluster von Batteriezellen bzw. Batteriezellen-Elementen in Form von Batteriezellen-(Sub-)Elementen umfassen.

Die Batteriezellen bzw. Batteriezellen-Elemente 21 können zu lediglich beispielhaften Gruppierungen oder Clustern 51 - 53 kombiniert sein. Auch die Cluster oder Gruppierungen lassen sich sodann wiederum selbst potentiell als Batteriezellen-Elemente 51 - 53 im Sinne der Erfindung auffassen. Die Erfindung ist diesbezüglich nicht limitiert.

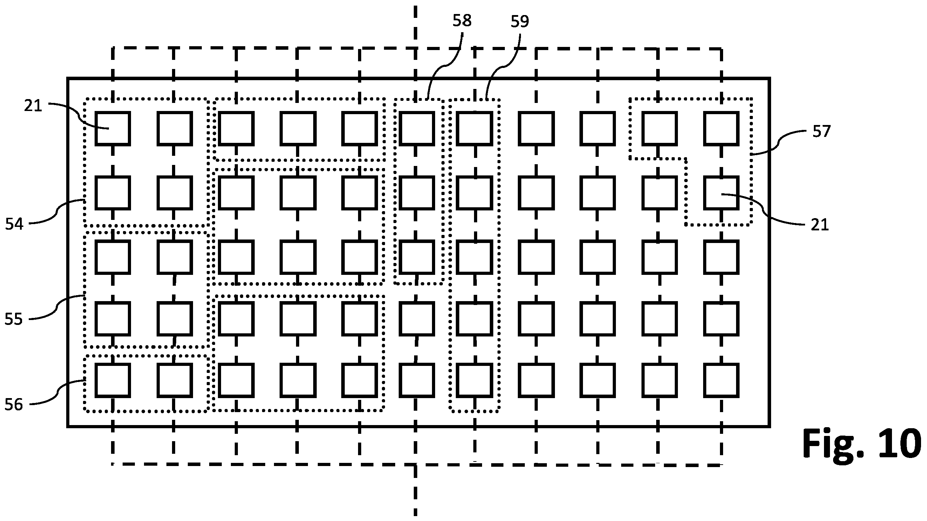

Die Figur 10 zeigt eine weitere schematische Darstellung eines weiteren beispielhaften Batteriesystems mit Batteriezellen-Elementen, welche Gruppierungen und/oder Cluster von Batteriezellen bzw. Batteriezellen-Elementen in Form von Batteriezellen-(Sub-)Elementen umfassen.

Die Batteriezellen bzw. Batteriezellen-Elemente 21 können so auch beispielsweise zu lediglich beispielhaften Gruppierungen oder Clustern 54 - 57 kombiniert sein. Auch die Cluster oder Gruppierungen lassen sich sodann wiederum selbst potentiell als Batteriezellen-Elemente 54 - 57 im Sinne der Erfindung auffassen. Die Erfindung ist diesbezüglich nicht limitiert.

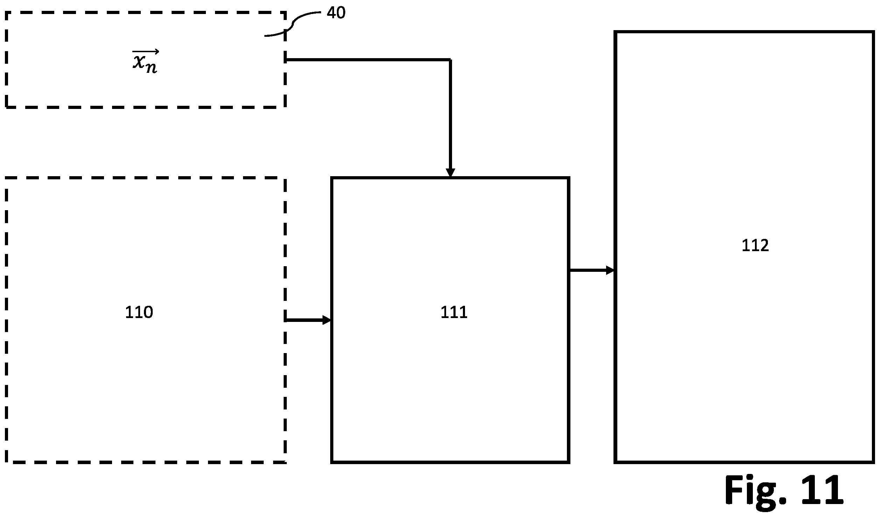

Die Figur 11 zeigt ein Struktur- bzw. Ablaufdiagramm zu einer Ausführungsform der vorliegenden Erfindung.

In einem Schritt 110 wird ein reduzierter Batteriezellen-Element-Mess-Datensatz bereitgestellt. Dieser kann beispielsweise von einem BMS erzeugt worden sein. Dieser Schritt des Erzeugens ist jedoch nicht für die Erfindung essentiell. Die Erfindung arbeitet lediglich mit einem reduzierten Batteriezellen-Element-Mess-Datensatz als Input.

In einem Schritt 111 erfolgt ein Bestimmen und/oder Vorhersehen einer Anomalie des Batteriesystems auf Basis des reduzierten Batteriezellen-Element-Mess-Datensatzes.

Beispielsweise werden dabei eine oder mehrere Kenngrößen und/oder Zustandsgrößen errechnet. Beispielsweise erfolgt daraufhin ferner ein Vergleich, welcher diese berechneten Größen (und beispielsweise passend gewählte Referenzwerte) involviert. Es sei hierzu auf den allgemeinen Teil der Erfindungsbeschreibung verwiesen.

In einem Schritt 112 erfolgt beispielsweise ein weiteres Verwerten der gewonnenen Erkenntnisse und Ergebnisse.

Bei der Analyse kann ferner ein Batteriezellen-Element-Identifikations-Datensatz 40 berücksichtigt werden. Die Hinzunahme dieses Datensatzes 40 erlaubt weitere Rückschlüsse, insbesondere für konkretere Lokalisierungen von Anomalien oder möglichen Anomalien innerhalb des Batteriesystems.

Der Batteriezellen-Element-Identifikations-Datensatz 40 kann häufig erst in einem zweiten Schritt zum Einsatz kommen, beispielsweise für eine Problemlokalisierung und/oder Lösungssuche, aber beispielsweise nachdem eine Anomalie bereits festgestellt und/oder vorhergesagt wurde. In einer bevorzugten Ausführungsform kommt so der Batteriezellen-Element-Identifikations-Datensatz 40 erst zum Einsatz, wenn und nachdem eine Anomalie festgestellt und/oder vorhergesagt wurde.

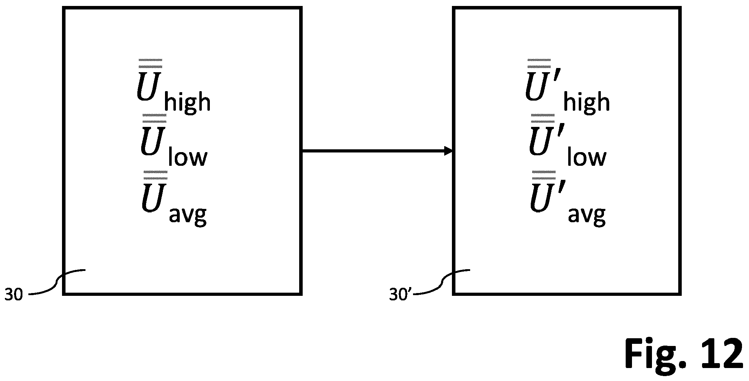

Die Figur 12 zeigt eine schematische Darstellung eines reduzierten Batteriezellen-Element-Mess-Datensatzes 30 sowie eines weiteren hierauf basierenden Datensatzes 30'.

In dem schematisch dargestellten umfasst der reduzierte Batteriezellen-Element-Mess-Datensatz 30 für eine erste Zustandsgröße $\overline{\overline{U}}$ drei Messdaten, welche als Maximalwert, Minimalwert und Durchschnittswert (average = avg) ausgewählt wurden.

Aus diesen Messdaten können beispielsweise Daten $\overline{\overline{U}}'$ berechnet werden. Dabei entsteht ein auf dem reduzierten Batteriezellen-Element-Mess-Datensatzes 30 basierender Datensatz 30'. Bei dessen Erzeugung aus den Messdaten des reduzierten Batteriezellen-Element-Mess-Datensatzes 30 können die einzelnen Messdaten untereinander mischen und/oder kombiniert werden: So kann beispielsweise in diesem Beispiel $\overline{\overline{U}}'_{high}$ von allen drei $\overline{\overline{U}}$-Werten des reduzierten Batteriezellen-Element-Mess-Datensatzes 30 abhängen. Dies wird beispielsweise auch zum Einsatz geeigneter Interpolationsverfahren genutzt.

Die erfindungsgemäßen Schritte des Bestimmens bzw. Vorhersehens einer Anomalie können (direkt) auf dem reduzierten Batteriezellen-Element-Mess-Datensatz 30 beruhen. Sie können aber auch, beispielsweise stattdessen, auf dem hierauf basierenden Datensatz 30' beruhen, ohne die Erfindung hiermit zu umgehen.

**Bezugszeichenliste**

| | |
|---|---|
| 1 | Energiespeicher/Batterie |
| 2 | Fahrzeug |
| 3 | Ladeeinrichtung |
| 4 | Ladekabel |
| 5 | Cloud-Server |
| 7 | Zwischenkreis |
| 8 | Sonstige Zwischenkomponenten |
| 9 | Impedanzen |
| 10 | Leistungskanäle |
| 11 | Pole des Zwischenkreises |
| 20 | Batteriesystem |
| 21 | Batteriezellen-Element |
| 30 | reduzierter Batteriezellen-Element-Mess-Datensatz |
| 30' | weiterer Datensatz, welcher auf dem reduzierten Batteriezellen-Element-Mess-Datensatz basiert |
| 40 | Batteriezellen-Element-Identifikations-Datensatzes |
| 51-59 | Gruppen/Cluster von Batteriezellen-Elementen (welche ebenfalls selbst Batteriezellen-Elemente darstellen können) |
| 110 | Schritt 0: Bereitstellung red. Batteriezellen-Element-Mess-Datensatz |
| 111 | Schritt 1: Anomalie-Analyse / -Vorhersage |
| 112 | Schritt 2: Weitere Verwertung von Analyseergebnissen und Erkenntnissen |

***Weitere Offenbarungen***

***(Ansprüche der Prioritätsanmeldung)***

1. Verfahren zum Erkennen und/oder Vorhersehen von Anomalien in einem Batteriesystem (20), umfassend zwei oder mehrere Batteriezellen-Elemente (21, 51-57), umfassend die folgenden Schritte:

- Bereitstellen eines reduzierten Batteriezellen-Element-Mess-Datensatzes (30), welcher auf Basis eines Batteriezellen-Element-Mess-Datensatzes, welcher je Batteriezellen-Element (21, 51-57) des Batteriesystems (20) eine oder mehrere erste Zustandsgrößen $(\overline{\overline{U}})$, insbesondere Temperatur, Stromfluss und/oder Spannung und/oder erste Zustandsgrößen, welche durch Kombinationen hieraus beschrieben sind, des jeweiligen Batteriezellen-Elements (21, 51-57) in Bezug auf einen oder mehrere Zeitpunkte als Messdatum umfasst, derart hergeleitet wurde, dass der reduzierte Batteriezellen-Element-Mess-Datensatzes für eine erste Zustandsgröße $(\overline{\overline{U}})$ und für einen Zeitpunkt

  ○ ein erstes, nach einem ersten Kriterium aus der Menge der Messdaten der Batteriezellen-Elemente (21, 51-57) aus dem Batteriezellen-Element-Mess-Datensatzes, für diesen Zeitpunkt und diese erste Zustandsgröße $(\overline{\overline{U}})$, ausgewähltes Messdatum, sowie
  ○ ein zweites, nach einem zweiten Kriterium aus der Menge der Messdaten der Batteriezellen-Elemente (21, 51-57) aus dem Batteriezellen-Element-Mess-Datensatzes, für diesen Zeitpunkt und diese erste Zustandsgröße $(\overline{\overline{U}})$, ausgewähltes Messdatum umfasst,

  oder eines auf dem reduzierten Batteriezellen-Element-Mess-Datensatz (30) basierenden Datensatzes (30)

- Bestimmen und/oder Vorhersehen einer Anomalie des Batteriesystems (20) auf Basis des reduzierten Batteriezellen-Element-Mess-Datensatzes (30) und/oder auf Basis des auf dem reduzierten Batteriezellen-Element-Mess-Datensatzes basierenden Datensatzes (30).

2. Verfahren nach Anspruch 1, wobei das erste Kriterium respektive zweite Kriterium derart beschaffen ist, dass ein Batteriezellen-Element aus dem Batteriezellen-Element-Mess-Datensatz ausgewählt wurde, dass die erste Zustandsgröße $(\overline{\overline{U}})$, unter den Batteriezellen-Elementen des Batteriezellen-Element-Mess-Datensatzes ein erstes respektive zweites Kriterium erfüllt.

3. Verfahren nach Anspruch 1 oder 2, wobei das erste Kriterium respektive zweite Kriterium derart beschaffen ist, dass ein Batteriezellen-Element aus dem Batteriezellen-Element-Mess-Datensatz ausgewählt wurde, dass die erste Zustandsgröße $(\overline{\overline{U}})$, unter den Batteriezellen-Elementen des Batteriezellen-Element-Mess-Datensatzes maximal respektive minimal ist.

4. Verfahren nach Anspruch 1, wobei das erste Kriterium respektive zweite Kriterium derart beschaffen ist, dass ein Batteriezellen-Element aus dem Batteriezellen-Element-Mess-Datensatz ausgewählt wurde, dass eine zweite Zustandsgröße $(\overline{U})$, insbesondere Temperatur, Stromfluss und/oder Spannung und/oder zweite Zustandsgrößen $(\overline{U})$, welche durch Kombinationen hieraus beschrieben sind, unter den Batteriezellen-Elementen des Batteriezellen-Element-Mess-Datensatzes ein erstes respektive zweites Kriterium erfüllt.

5. Verfahren nach Anspruch 1 oder 4, wobei das erste Kriterium respektive zweite Kriterium derart beschaffen ist, dass ein Batteriezellen-Element aus dem Batteriezellen-Element-Mess-Datensatz ausgewählt wurde, dass eine zweite Zustandsgröße $(\overline{U})$, insbesondere Temperatur, Stromfluss und/oder Spannung und/oder zweite Zustandsgrößen $(\overline{U})$, welche durch Kombinationen hieraus beschrieben sind, unter den Batteriezellen-Elementen des Batteriezellen-Element-Mess-Datensatzes maximal respektive minimal ist.

6. Verfahren nach Anspruch 5, wobei die erste $(\overline{\overline{U}})$ und die zweite $(\overline{U})$ Zustandsgröße voneinander verschieden sind, insbesondere zwei verschiedene aus: Temperatur, Stromfluss und/oder Spannung und/oder Zustandsgröße, welche durch Kombinationen hieraus beschrieben sind.

7. Verfahren nach Anspruch 5, wobei die erste $(\bar{\bar{U}})$ und die zweite $(\bar{U})$ Zustandsgröße zusammenfallen und/oder identisch definiert sind, insbesondere als eines aus: Temperatur, Stromfluss und/oder Spannung und/oder Zustandsgröße, welche durch Kombinationen hieraus beschrieben sind.

8. Verfahren nach einem der vorhergehenden Ansprüche, wobei das erste Kriterium und/oder zweite Kriterium derart beschaffen ist, dass ein Batteriezellen-Element aus dem Batteriezellen-Element-Mess-Datensatz ausgewählt wurde, dass die zweite Zustandsgröße $(\bar{U})$, unter den Batteriezellen-Elementen des Batteriezellen-Element-Mess-Datensatzes in Bezug auf die übrigen Batteriezellen-Elementen eine oder mehrere der folgenden Bedingungen erfüllt:

- Maximalwert unter den Batteriezellen-Elementen,
- Minimalwert unter den Batteriezellen-Elementen,
- Mittelwert unter den Batteriezellen-Elementen, insbesondere gewichtet, ungewichtet, arithmetisch und/oder geometrisch,
- Median unter den Batteriezellen-Elementen,
- Perzentil unter den Batteriezellen-Elementen, insbesondere vordefiniertes Perzentil.

9. Verfahren nach einem der vorhergehenden Ansprüche, wobei der bereitgestellte reduzierte Batteriezellen-Element-Mess-Datensatz ferner ein drittes, nach einem dritten Kriterium aus der Menge der Messdaten der Batteriezellen-Elemente aus dem Batteriezellen-Element-Mess-Datensatz, für diesen Zeitpunkt und die erste Zustandsgröße $(\bar{\bar{U}})$, ausgewähltes Messdatum umfasst,
wobei insbesondere das dritte Kriterium derart beschaffen ist, dass ein Batteriezellen-Element aus dem Batteriezellen-Element-Mess-Datensatz ausgewählt wurde, dass die zweite Zustandsgröße $(\bar{U})$, unter den Batteriezellen-Elementen des Batteriezellen-Element-Mess-Datensatzes in Bezug auf die übrigen Batteriezellen-Elementen eine oder mehrere der folgenden Bedingungen erfüllt:

- ○ Mittelwert unter den Batteriezellen-Elementen, insbesondere gewichtet, ungewichtet, arithmetisch und/oder geometrisch,
- ○ Median unter den Batteriezellen-Elementen,
- ○ Perzentil unter den Batteriezellen-Elementen, insbesondere vordefiniertes Perzentil.

10. Verfahren nach einem der vorhergehenden Ansprüche, wobei der Schritt des Bestimmens und/oder Vorhersehens einer Anomalie des Batteriesystems auf Basis des reduzierten Batteriezellen-Element-Mess-Datensatzes (30) und/oder des hierauf basierenden Datensatzes (30) ferner umfasst einen Schritt eines Errechnens einer oder mehrerer Kenngrößen und/oder Zustandsgrößen für das Batteriesystem,
insbesondere eines oder mehrere aus: Widerstand, Impedanz, Kapazität, Gesundheitszustand, State of Health, Ladezustand, State of Charge, Temperatur und/oder Kombinationen hieraus,
auf Basis des reduzierten Batteriezellen-Element-Mess-Datensatzes (30) und/oder des hierauf basierenden Datensatzes (30).

11. Verfahren nach einem der vorhergehenden Ansprüche, wobei zur Anomaliebestimmung und/oder -vorhersage aus dem reduzierten Batteriezellen-Element-Mess-Datensatzes (30) und/oder des hierauf basierenden Datensatzes (30) eine oder zwei Abschätzungen von Zustandsgrößen des Batteriesystems, insb. Ladezustände, Widerstände, thermische Eigenschaften, Kapazitäten, Verschleißgrade, Abnahme/Zunahme von Aktivmaterial, Veränderung von Materialien, Materialzusammensetzung und Materialverteilungen, Veränderung in der chemischen Zusammensetzung, Auftreten metallischen Lithiums (Plating), ermittelt und der zeitliche Verlauf dieser Abschätzungen auf Veränderungen untersucht wird.

12. Verfahren nach Anspruch 10 oder 11, wobei der Schritt Errechnens und/oder Abschätzens einer oder mehrerer Kenngrößen und/oder Zustandsgrößen derart erfolgt, dass mindestens eine Kenngröße und/oder Zustandsgröße jeweils nur auf einem Messdatum eines Batteriezellen-Element-Mess-Datensatzes (30) und/oder eines hierauf basierenden Datensatzes (30) beruht.

13. Verfahren nach Anspruch 10 oder 11, wobei der Schritt Errechnens und/oder Abschätzens einer oder mehrerer Kenngrößen und/oder Zustandsgrößen derart erfolgt, dass mindestens eine Kenngröße und/oder Zustandsgröße jeweils auf mehreren Messdaten eines Batteriezellen-Element-Mess-Datensatzes (30) und/oder eines hierauf basierenden Datensatzes (30) beruht,
insbesondere auf zweien, dabei insbesondere einem Minimalwert und Maximalwert, oder auf dreien, dabei insbesondere einem Minimalwert, einem Maximalwert und einer Art Mittelwert.

14. Verfahren nach Anspruch 10, 11 oder 13, wobei ein State of Charge auf Basis mindestens zweier der folgenden drei Werte aus den Messdaten eines Batteriezellen-Element-Mess-Datensatzes (30) und/oder eines hierauf basierenden Datensatzes (30) ermittelt wird: Maximalwert, Minimalwert, Mittelwert.

15. Verfahren nach einem der Ansprüche 10 - 14, wobei der Schritt eines Errechnens einer Kenngröße auf Basis der Elemente des reduzierten Batteriezellen-Element-Mess-Datensatzes (30) und/oder des hierauf basierenden Datensatzes (30) unter Ausschluss einer Verwertung der übrigen Elemente eines Batteriezellen-Element-Mess-Datensatzes vor der Reduktion erfolgt.

16. Verfahren nach einem der Ansprüch 10 - 15, wobei eine oder mehrere Kenngrößen je Zeitpunkt gespeichert werden.

17. Verfahren nach einem der vorhergehenden Ansprüche, ferner umfassend die Übermittlung eines reduzierten Batteriezellen-Element-Mess-Datensatzes (30) und/oder des hierauf basierenden Datensatzes (30) in eine Computing-Cloud und/oder einen Server oder ein Servernetzwerk, insbesondere über ein Funknetzwerk, Wifi oder ein Subscriber-Identity-Modul.

18. Verfahren nach einem der Ansprüche 10 - 17, ferner umfassend ein Vergleichen einer oder mehrerer Kenngrößen oder errechneter Größen mit einer oder mehrerer Referenzgrößen.

19. Verfahren nach Anspruch 18, wobei der Schritt des Vergleichens basiert auf einer Vergleichsmethode, welche eines oder mehrere beinhaltet aus:

- Größer- und/oder Kleiner-Operator, insbesondere Größer-Gleich- und/oder Keiner-Gleich-Operator, insbesondere bezüglich eines Durchschnittswerts und/oder eines Schwellenwertes,
- Bilden eines Durchschnittswerts,
- Trendanalyse, und/oder
- Detektion von Outlier-Werten.

20. Verfahren nach einem der vorhergehenden Ansprüche, ferner umfassend einen Schritt eines Bereitstellens eines Batteriezellen-Element-Identifikations-Datensatzes, welcher umfasst:

- mindestens ein Identifikations- und/oder Zuordnungs-Datum, welches eine Identifikation und/oder Zuordnung eines Elements des reduzierten Batteriezellen-Element-Mess-Datensatzes, insbesondere auch eines Elements eines auf dem reduzierten Batteriezellen-Element-Mess-Datensatz basierenden Datensatzes, zu einem oder mehreren zugehörigen Batteriezellen-Elementen des Batteriesystems ermöglicht.

21. Verfahren nach Anspruch 20, wobei das Identifikations- und/oder Zuordnungs-Datum eines oder mehrere umfasst aus:

- eine Zell-ID oder eine Zell-Nummer
- eine Information zu einer geometrischen Position, insbesondere ungefähre und/oder genäherte Position, einer Zelle
- eine ID einer Gruppe von Zellen und/oder eines logischen Clusters von Zellen.

22. Verfahren nach einem der Ansprüche 20 oder 21, wobei das Identifikations- und/oder Zuordnungs-Datum eindeutig innerhalb des Batteriesystems ist.

23. Verfahren nach einem der Ansprüche 20 oder 21, wobei das Identifikations- und/oder Zuordnungs-Datum nicht eindeutig innerhalb des Batteriesystems ist.

24. Verfahren nach einem der Ansprüche 20 - 23, wobei der Schritt des Bestimmens und/oder Vorhersehens einer Anomalie des Batteriesystems ferner einen Schritt eines Lokalisierens der Anomalie innerhalb des Batteriesystems unter Nutzung des Batteriezellen-Element-Identifikations-Datensatzes umfasst.

25. Verfahren nach Anspruch 24, wobei das Lokalisieren der Anomalie innerhalb des Batteriesystems darauf basiert, wie häufig ein Identifikations- und/oder Zuordnungs-Datum innerhalb eines Betrachtungszeitraumes auftritt.

26. Verfahren nach Anspruch 25, wobei das Batteriesystem in logische Cluster gruppiert ist und das Lokalisieren der Anomalie innerhalb des Batteriesystems ferner darauf basiert, wie häufig Identifikations- und/oder Zuordnungs-Daten, welche in einen bestimmten Cluster des Batteriesystems fallen, innerhalb eines Betrachtungszeitraumes auftreten.

27. Verfahren nach einem der vorhergehenden Ansprüche, wobei der Schritt des Bestimmens und/oder Vorhersehens einer Anomalie des Batteriesystems den Einsatz einer Künstlichen Intelligenz, insbesondere eines Maschinenlern-Modells, umfasst.

28. Verfahren nach Anspruch 27, wobei die Künstliche Intelligenz als Eingabegröße den reduzierten Batteriezellen-Element-Mess-Datensatz, insbesondere auch eines oder mehrere Elemente eines Batteriezellen-Element-Identifikations-Datensatzes, umfasst.

29. Verfahren nach einem der vorhergehenden Ansprüche, ferner umfassend einen expliziten Schritt eines Erzeugens des reduzierten Batteriezellen-Element-Mess-Datensatzes auf Basis des Batteriezellen-Element-Mess-Datensatzes.

30. Verfahren zum Trainieren einer Künstlichen Intelligenz zum Erkennen und/oder Vorhersehen von Anomalien in einem Batteriesystem, umfassend zwei oder mehrere Batteriezellen-Elemente, umfassend die folgenden Schritte:

- Bereitstellen eines reduzierten Batteriezellen-Element-Mess-Datensatzes, welcher auf Basis eines Batteriezellen-Element-Mess-Datensatzes, welcher je Batteriezellen-Element des Batteriesystems eine oder mehrere erste Zustandsgrößen $(\overline{\overline{U}})$,

  insbesondere Temperatur, Stromfluss und/oder Spannung und/oder erste Zustandsgrößen, welche durch Kombinationen hieraus beschrieben sind, des jeweiligen Batteriezellen-Elements in Bezug auf einen oder mehrere Zeitpunkte als Messdatum umfasst, derart hergeleitet wurde, dass der reduzierte Batteriezellen-Element-Mess-Datensatzes für eine erste Zustandsgröße ($\overline{\overline{U}}$) und für einen Zeitpunkt

  ◦ ein erstes, nach einem ersten Kriterium aus der Menge der Messdaten der Batteriezellen-Elemente aus dem Batteriezellen-Element-Mess-Datensatzes, für diesen Zeitpunkt und diese erste Zustandsgröße ($\overline{\overline{U}}$), ausgewähltes Messdatum, sowie
  ◦ ein zweites, nach einem zweiten Kriterium aus der Menge der Messdaten der Batteriezellen-Elemente aus dem Batteriezellen-Element-Mess-Datensatzes, für diesen Zeitpunkt und diese erste Zustandsgröße ($\overline{\overline{U}}$), ausgewähltes Messdatum umfasst,

  oder eines auf dem reduzierten Batteriezellen-Element-Mess-Datensatz (30) basierenden Datensatzes (30'),

- Eingeben des reduzierten Batteriezellen-Element-Mess-Datensatzes (30) oder Eingeben des auf dem reduzierten Batteriezellen-Element-Mess-Datensatzes basierenden Datensatzes (30'), als Eingangsgrößen in die Künstliche Intelligenz, insbesondere das Maschinen-Lern-Modell.

31. Vorrichtung, insbesondere Computer, Computernetzwerk oder Computing-Cloud, welche dazu eingerichtet ist, ein Verfahren nach einem der vorhergehenden Ansprüche zu bewirken.

32. Datenträger, computerlesbar oder menschenlesbar, umfassend ein Bestimmungs- und/oder Vorhersageergebnis bezüglich einer möglichen Anomalie eines Batteriesystems, erhalten gemäß einem Verfahren nach einem der Ansprüche 1 - 29.

*33. Computerprogramm, welches bei Ausführung, lokal und/oder verteilt, ein Verfahren nach einem der Ansprüche 1 - 30 bewirkt.*

*34. Computerlesbares Speichermedium, umfassend das Computerprogramm nach Anspruch 33.*

**Patentansprüche**

**1.** Verfahren zum Erkennen und/oder Vorhersehen von Anomalien in einem Batteriesystem (20), umfassend zwei oder mehrere Batteriezellen-Elemente (21, 51-57), umfassend die folgenden Schritte:

• Bereitstellen der minimalen Spannung und der maximalen Spannung (30, $\overline{U}$, $\overline{\overline{U}}$) im Batteriesystem (20) als die Spannung des Batteriezellen-Elements (21) mit der niedrigsten Spannung $(\overline{\overline{U}}_{low})$ und die Spannung des Batteriezellen-Elements (21) mit der höchsten Spannung $(\overline{\overline{U}}_{high})$, respektive, auf Basis mehrerer Einzelspannungen $(\overline{U}, \overline{\overline{U}})$ mehrerer Batteriezellen-Elemente (21),

• Bestimmen und/oder Vorhersehen einer Anomalie des Batteriesystems (20), insbesondere eines oder mehrere aus:

- einer Abschätzung der Spreizung der Kapazität innerhalb des Batteriesystems,
- einer Abschätzung der Größenordnung der Abweichung der Kapazitäten von Batteriezellen-Elementen voreinander,
- einer Abschätzung des Vorliegens von Anzeichen für beschleunigten Kapazitätsverfall einzelner oder weniger Batteriezellen-Elemente,
- einer Abschätzung der Größenordnung der Abweichung von Widerständen von Batteriezellen-Elementen voreinander,
- einer Abschätzung des Vorliegens von Anzeichen von Defekten einzelner oder weniger Batteriezellen-Elemente,
- eine Abschätzung des Vorliegens von Anzeichen von Lithium-Plating und/oder Auftretens von metallischem Lithium und/oder Auftreten ungewollter metallischer Abscheidungen,
- eine Abschätzung des Vorliegens von Anzeichen von internen Kurzschlüssen,

auf Basis der minimalen $(\overline{\overline{U}}_{low})$ Spannung und der maximalen $(\overline{\overline{U}}_{high})$ Spannung (30, $\overline{U}$, $\overline{\overline{U}}$)

**2.** Verfahren zum Trainieren einer Künstlichen Intelligenz zum Erkennen und/oder Vorhersehen von Anomalien in einem Batteriesystem (20), umfassend zwei oder mehrere Batteriezellen-Elemente (21, 51-57), umfassend die folgenden Schritte:

• Bereitstellen der minimalen Spannung und der maximalen Spannung (30, $\overline{U}$, $\overline{\overline{U}}$) im Batteriesystem (20) als die Spannung des Batteriezellen-Elements (21) mit der niedrigsten Spannung $(\overline{\overline{U}}_{low})$ und die Spannung des Batteriezellen-Elements (21) mit der höchsten Spannung $(\overline{\overline{U}}_{high})$, respektive, auf Basis mehrerer Einzelspannungen $(\overline{U}, \overline{\overline{U}})$ mehrerer Batteriezellen-Elemente (21),

• Eingeben der minimalen $(\overline{\overline{U}}_{low})$ Spannung und der maximalen $(\overline{\overline{U}}_{high})$ Spannung (30, $\overline{U}$, $\overline{\overline{U}}$) als Eingangsgrößen in die Künstliche Intelligenz, insbesondere das Maschinen-Lern-Modell

wobei Anomalien insbesondere umfassen eines oder mehrere aus:

- einer Abschätzung der Spreizung der Kapazität innerhalb des Batteriesystems,
- einer Abschätzung der Größenordnung der Abweichung der Kapazitäten von Batteriezellen-Elementen voreinander,

- einer Abschätzung des Vorliegens von Anzeichen für beschleunigten Kapazitätsverfall einzelner oder weniger Batteriezellen-Elemente,
- einer Abschätzung der Größenordnung der Abweichung von Widerständen von Batteriezellen-Elementen voreinander,
- einer Abschätzung des Vorliegens von Anzeichen von Defekten einzelner oder weniger Batteriezellen-Elemente,
- eine Abschätzung des Vorliegens von Anzeichen von Lithium-Plating und/oder Auftretens von metallischem Lithium und/oder Auftreten ungewollter metallischer Abscheidungen,
- eine Abschätzung des Vorliegens von Anzeichen von internen Kurzschlüssen.

3. Verfahren nach einem der vorhergehenden Ansprüche, ferner umfassend einen expliziten Schritt eines Ermittelns der minimalen Spannung und der maximalen Spannung $(30, \overline{U}, \overline{\overline{U}})$ im Batteriesystem (20) auf Basis der mehreren Einzelspannungen $(\overline{U}, \overline{\overline{U}})$ der mehreren Batteriezellen-Elemente (21).

4. Verfahren nach einem der vorhergehenden Ansprüche, wobei ferner eine dritte Spannung ($\overline{\overline{U}}_x$) im Batteriesystem (20) bereitgestellt wird, welche nach einem dritten Kriterium ausgewählt ist, auf Basis der mehreren Einzelspannungen $(\overline{U}, \overline{\overline{U}})$ der mehreren Batteriezellen-Elemente (21).

5. Verfahren nach Anspruch 4, wobei als drittes Kriterium eine oder mehrere der folgenden Bedingungen in Bezug auf die dritte Spannung ($\overline{\overline{U}}_x$) eingesetzt werden:

   ∘ Mittelwert unter den Batteriezellen-Elementen (21, 51-57), insbesondere gewichtet, ungewichtet, arithmetisch und/oder geometrisch,
   ∘ Median unter den Batteriezellen-Elementen (21, 51-57),
   ∘ Perzentil unter den Batteriezellen-Elementen (21, 51-57), insbesondere vordefiniertes Perzentil.

6. Verfahren nach einem der vorhergehenden Ansprüche, ferner umfassend einen Schritt eines Bereitstellens eines Batteriezellen-Element-Identifikations-Datensatzes, welcher umfasst:

   - mindestens ein Identifikations- und/oder Zuordnungs-Datum, welches eine Identifikation und/oder Zuordnung der minimalen ($\overline{\overline{U}}_{low}$) Spannung und der maximalen ($\overline{\overline{U}}_{high}$) Spannung $(30, \overline{U}, \overline{\overline{U}})$ im Batteriesystem (20) zu einem oder mehreren zugehörigen Batteriezellen-Elementen (21, 51-57) des Batteriesystems (20) ermöglicht.

7. Verfahren nach Anspruch 6, wobei mindestens ein Identifikations- und/oder Zuordnungs-Datum eines oder mehrere umfasst aus:

   - eine Zell-ID oder eine Zell-Nummer
   - eine Information zu einer geometrischen Position, insbesondere ungefähre und/oder genäherte Position, einer Zelle
   - eine ID einer Gruppe von Zellen und/oder eines logischen Clusters von Zellen.

8. Verfahren nach einem der Ansprüche 6 oder 7, wobei das Identifikations- und/oder Zuordnungs-Datum eindeutig innerhalb des Batteriesystems (20) ist.

9. Verfahren nach einem der Ansprüche 6 oder 7, wobei das Identifikations- und/oder Zuordnungs-Datum nicht eindeutig innerhalb des Batteriesystems (20) ist.

10. Verfahren nach einem der vorhergehenden Ansprüche, wobei der Schritt des Bestimmens und/oder Vorhersehens einer Anomalie des Batteriesystems (20) auf Basis der minimalen ($\overline{\overline{U}}_{low}$) Spannung und der maximalen ($\overline{\overline{U}}_{high}$) Spannung $(30, \overline{U}, \overline{\overline{U}})$ ferner umfasst einen Schritt eines Errechnens einer oder mehrerer Kenngrößen und/oder Zustandsgrößen für das Batteriesystem,
insbesondere eines oder mehrere aus: Widerstand, Impedanz, Kapazität, Gesundheitszustand, State of Health, Ladezustand, State of Charge, Temperatur und/oder Kombinationen hieraus,

auf Basis der minimalen ( $\overline{\overline{U}}_{low}$ ) Spannung und der maximalen ( $\overline{\overline{U}}_{high}$ ) Spannung (30, $\overline{U}$, $\overline{\overline{U}}$ ) des Batteriesystems (20).

11. Verfahren nach einem der vorhergehenden Ansprüche, wobei zur Anomaliebestimmung und/oder -vorhersage aus der minimalen ( $\overline{\overline{U}}_{low}$ ) Spannung und der maximalen ( $\overline{\overline{U}}_{high}$ ) Spannung (30, $\overline{U}$, $\overline{\overline{U}}$ ) eine oder zwei Abschätzungen von Zustandsgrößen des Batteriesystems, insb. Ladezustände, Widerstände, thermische Eigenschaften, Kapazitäten, Verschleißgrade, Abnahme/Zunahme von Aktivmaterial, Veränderung von Materialien, Materialzusammensetzung und Materialverteilungen, Veränderung in der chemischen Zusammensetzung, Auftreten metallischen Lithiums (Plating), ermittelt werden und der zeitliche Verlauf dieser Abschätzungen auf Veränderungen untersucht wird.

12. Verfahren nach Anspruch 10 oder 11, wobei der Schritt Errechnens und/oder Abschätzens einer oder mehrerer Kenngrößen und/oder Zustandsgrößen derart erfolgt, dass mindestens eine Kenngröße und/oder Zustandsgröße jeweils nur auf einer Spannung von der minimalen ( $\overline{\overline{U}}_{low}$ ) Spannung und der maximalen ( $\overline{\overline{U}}_{high}$ ) Spannung (30, $\overline{U}$, $\overline{\overline{U}}$ ) beruht.

13. Verfahren nach einem der vorhergehenden Ansprüche, wobei ein State of Charge auf Basis mindestens zweier der folgenden drei Werte ( $\overline{\overline{U}}_{low}, \overline{\overline{U}}_{high}, \overline{\overline{U}}_{avg}$ ) aus den Spannungsmessdaten ( $\overline{\overline{U}}_{low}, \overline{\overline{U}}_{high}, \overline{\overline{U}}_{x}$ ) des Batteriesystems (20) ermittelt wird: Maximalwert ( $\overline{\overline{U}}_{high}$ ), Minimalwert ( $\overline{\overline{U}}_{low}$ ), Mittelwert ( $\overline{\overline{U}}_{avg}$ ).

14. Vorrichtung, insbesondere Computer, Computernetzwerk oder Computing-Cloud, welche dazu eingerichtet ist, ein Verfahren nach einem der vorhergehenden Ansprüche zu bewirken.

15. Computerprogramm, welches bei Ausführung, lokal und/oder verteilt, ein Verfahren nach einem der Ansprüche 1 - 13 bewirkt, oder computerlesbares Speichermedium, umfassend das Computerprogramm.

Fig. 1

Fig. 2

EP 4 376 167 A2

**Fig. 3**

Fig. 4

Fig. 5

**Fig. 6**

Fig. 7

Fig. 8

Fig. 9

**Fig. 10**

EP 4 376 167 A2

**Fig. 11**

EP 4 376 167 A2

$$\overline{\overline{U}}_{high}$$
$$\overline{\overline{U}}_{low}$$
$$\overline{\overline{U}}_{avg}$$

30

$$\overline{\overline{U}}'_{high}$$
$$\overline{\overline{U}}'_{low}$$
$$\overline{\overline{U}}'_{avg}$$

30'

**Fig. 12**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20210049480 A1